# EUROPÄISCHE PATENTSCHRIFT

(11) **EP 3 329 621 B1**
(45) Veröffentlichungstag und Bekanntmachung des Hinweises auf die Patenterteilung: **25.09.2019**
(21) Anmeldenummer: 16750691.4
(22) Anmeldetag: 29.07.2016
(51) Int. Cl.: H04L 1/00, H04L 1/20, H04L 25/06, H03M 13/37

(54) **DRAHTLOSES ÜBERTRAGUNGSVERFAHREN FÜR EINFACHE EMPFÄNGER**
WIRELESS TRANSMISSION METHOD FOR SIMPLE RECEIVERS
PROCEDE DE TRANSMISSION SANS FIL POUR UN RECEPTEUR SIMPLE

(30) Priorität: 30.07.2015 EP 15179182
(43) Veröffentlichungstag der Anmeldung: 06.06.2018
(73) Patentinhaber: Fraunhofer Gesellschaft zur Förderung der angewandten Forschung E.V., 80686 München (DE)
(72) Erfinder: KILIAN, Gerd, 91056 Erlangen (DE); KNEISSL, Jakob, 90765 Fürth (DE); WECHSLER, Johannes, 91174 Spalt (DE); BERNHARD, Josef, 92507 Nabburg (DE)
(74) Vertreter: Hersina, Günter
(86) Internationale Anmeldenummer: PCT/EP2016/068176
(87) Internationale Veröffentlichungsnummer: WO 2017/017257

(56) Entgegenhaltungen:
- WO-A1-97/50198
- US-A- 5 621 764
- MICHAEL BB PURSLEY ED - WICKER STEPHEN B ET AL: "Reed-Solomon Codes in Frequency-Hop Communications", 1. Januar 1999 (1999-01-01), REED-SOLOMON CODES AND THEIR APPLICATIONS, IEEE PRESS, USA, PAGE(S) 150 - 174, XP009188010, ISBN: 978-0-7803-5391-6 Seite 162 - Seite 165
- PURSLEY ET AL: "TRADEOFFS BETWEEN SIDE INFORMATION AND CODE RATE IN SLOW-FREQUENCY-HOP PACKET RADIO NETWORKS", IEEE INTERNATIONAL CONFERENCE ON COMMUNICATIONS '87: COMMUNICATIONS - SOUND TO LIGHT,, 1. Januar 1987 (1987-01-01), Seiten 947-952, XP009188000,

## Beschreibung

Ausführungsbeispiele der vorliegenden Erfindung beziehen sich auf einen Datenempfänger zum Empfangen von Nutzdaten, und im speziellen, auf einen Datenempfänger, der eine gewichtungsabhängige Kanaldecodierung von kanalcodierte Nutzdaten, die von einem einfachen Empfängerchip bereitgestellt werden, durchführt. Weitere Ausführungsbeispiele beziehen sich auf ein Verfahren zum Empfangen von Nutzdaten. Manche Ausführungsbeispiele beziehen sich auf ein drahtloses Übertragungsverfahren für einfache Empfänger.

Es sind verschiedene unidirektionale und bidirektionale Systeme für die Übertragung von Daten zwischen Basisstationen und Knoten bekannt, wie zum Beispiel DECT (DECT = Digital Enhanced Cordless Telecommunications, dt. ein internationaler Standard für Telekommunikation mittels Funktechnik) und RFID (RFID = Radio-Frequency Identification, dt. Identifizierung mit Hilfe elektromagnetischer Wellen). Typisch an diesen Systemen ist, dass die Basisstation eine Referenzfrequenz und eine Referenzzeit vorgibt, auf die sich die Teilnehmer synchronisieren. Bei RFID Systemen beispielsweise gibt der Reader (dt. Leser) ein Zeitfenster vor, das unmittelbar nach seiner Aussendung folgt, innerhalb dessen sich die RFID-Transponder zufällig einen Zeitpunkt für die Rückantwort aussuchen. Das vorgegebene Zeitintervall ist zudem in Zeitschlitze gleicher Länger unterteilt. Man spricht hier von einem Slötted Aloha Protokoll. Bei DECT wiederum sind Zeitschlitze innerhalb eines fest vorgegebenen Rasters vorgesehen. Die Basisstation ordnet hier einem Teilnehmer einen exakten Zeitschlitz zu, den er für die Kommunikation verwenden darf. Aufgrund der Ungenauigkeit durch die Quarztoleranz ist zwischen den Zeitschlitzen eine Pufferzeit vorgesehen, damit sich die Telegramme nicht überlagern.

Die DE 10 2011 082 098 B4 beschreibt eine batteriebetriebene stationäre Senderanordnung und ein Verfahren zum Senden eines Sensordatenpakets, bei dem das Sensordatenpaket in mehrere Dätenpakete unterteilt wird, die kleiner sind als die eigentliche Information, die übertragen werden soll (engl. Telegram Splitting), Telegramme werden dabei auf mehrere Teilpakete aufgeteilt. Ein solches Teilpaket wird als Hop bezeichnet. In einem Hop werden mehrerer Information Symbole übertragen. Die Hops werden auf einer Frequenz oder aber über mehrere Frequenzen verteilt (engl. Frequency Hopping) gesendet. Zwischen den Hops gibt es Pausen, in denen nicht gesendet wird.

Da nicht nur das Senden von Daten sondern auch das Empfangen selbiger einen vergleichsweise hohen Energieverbrauch nach sich zieht, kann das gleiche System auch für den umgekehrten Fall genutzt werden, bei dem Daten von der Basisstation zum Knoten übertragen werden. Auch in diesem Szenario ist der Energieverbrauch der Knoten kleinzuhalten, da die Knoten eventuell keine konstante Stromversorgung besitzen, sondern Energy Harvesting (dt. Energie-Ernten) betreiben, bei dem die Knoten die Energie aus der Umgebung beziehen (z.B. Temperaturunterschiede, Sonnenlicht, Elektromagnetische Wellen usw.) oder, wie bei der DE 10 2011 082 098 B4 für das Senden hier entsprechend für den Empfang eine Batterie zur Verfügung steht, die den Strom für den Empfänger nicht über eine genügend lange Zeit liefern kann.

Neben dem Energieverbrauch sind auch die Kosten ein maßgebendes Kriterium beim Design eines Empfangsknotens. Aufgrund dessen finden sich auf diesen Knoten meist sehr einfache Funkchips (Receiver oder Transceiver), die günstig in der Anschaffung sind und energiesparend arbeiten können. Doch diesen Funkchips fehlt es aufgrund ihres einfachen Aufbaus an Fähigkeiten detaillierte Informationen über die Qualität des Kanals oder der empfangenen Daten zu ermitteln. Auch bieten solche Funkchips keine Möglichkeit die Informationen die zur Berechnung notwendig wären, einem anderen Chip bereitzustellen. Außerdem würde die exakte Kanalanalyse in einem, externen Controller ebenso einen signifikanten Energieverbrauch verursachen. In der Regel liefern diese kostengünstigen Empfängerchips an Ihrem Ausgang eine bereits demodulierte digitale Bitfolge (=entschiedene Bits).

In dem Buch von "Reed-Solomon Codes and Their Applications" von 1999 von Stephen Wicker und Vijay Bhargava wird im Kapitel "Reed-Solomon Codes in Frequency-Hop Communications" von Michael Pursley ein Verfahren beschrieben, bei dem vom Sender Test-Symbole in den Datenstrom eingefügt werden. Auf Empfangsseite wird die Anzahl der Fehler in den Test-Symbolen bestimmt, und in Abhängigkeit davon werden Datensymbole durch Auslöschungen ersetzt.

Aus dem Artikel "Tradeoffs between side information and code rate in slow-frequencyhop packet radio networks" von Micheal Pursley, IEEE International Conference on Communications 87, 1987, wird ein Verfahren offenbart, bei dem ein Block für unzuverlässig erklärt wird, wenn ein oder zwei Testsequenzen des Blocks zu viele Fehler aufweisen.

Der vorliegenden Erfindung liegt somit die Aufgabe zugrunde, ein Konzept zu schaffen, welches eine Empfangsqualität bei Verwendung von kostengünstigen Empfängerchips verbessert.

Diese Aufgabe wird durch die unabhängigen Patentansprüche gelöst.

Vorteilhafte Weiterbildungen finden sich in den abhängigen Patentansprüchen.

Ausführungsbeispiele der vorliegenden Erfindung schaffen einen Datenempfänger zum Empfangen von Nutzdaten, die von einem Datensender mittels zumindest eines Datenpakets über einen Kommunikationskanal gesendet werden. Der Datenempfänger umfasst eine

Einrichtung zum Empfangen von Datenpaketen, die ausgebildet ist, um das zumindest eine Datenpaket zu empfangen, wobei das zumindest eine Datenpaket kanalkodierte Nutzdaten und zumindest einen Indikator aufweist, wobei die Einrichtung zum Empfangen von Datenpaketen ausgebildet ist, um für das zumindest eine empfangene Datenpaket empfangene Daten, die die empfangenen kanalkodierten Nutzdaten und den zumindest einen empfangenen Indikator umfassen, auszugeben. Ferner umfasst der Datenempfänger eine Einrichtung zum Weiterverarbeiten von empfangenen Daten, die ausgebildet ist, um aus den empfangenden Daten die empfangenen kanalkodierten Nutzdaten und den zumindest einen empfangenen Indikator zu ermitteln, und um den zumindest einen empfangenen Indikator des zumindest einen empfangenen Datenpaketes mit zumindest einem Referenzindikator, der dem Datensender und Datenempfänger bekannt ist, zu vergleichen, und um basierend auf dem Vergleich zwischen dem zumindest einen empfangenen Indikator und dem zumindest einen Referenzindikator zumindest einen Störungsgrad der empfangenen kanalcodierten Nutzdaten des zumindest einen empfangenen Datenpaketes zu ermitteln. Die Einrichtung zum Weiterverarbeiten von empfangenen Daten ist dabei ausgebildet, um die empfangenen kanalcodierten Nutzdaten des zumindest einen empfangenen Datenpakets basierend auf dem ermittelten zumindest einen Störungsgrad für eine Decodierung zu gewichten, und um eine von der Gewichtung der empfangenen kanalcodierten Nutzdaten abhängige Kanaldecodierung durchzuführen, um die Nutzdaten zu erhalten.

Der vorliegenden Erfindung liegt die Idee zugrunde, die in dem Datenpaket enthaltenen Nutzdaten zusätzlich mit zumindest einem Indikator zu versehen, so dass ein Störungsgrad der von der Einrichtung zum Empfangen von Datenpaketen (z.B. ein einfacher, kostengünstiger Funkchip) bereitgestellten empfangen Daten (z.B. bereits entschiedene Bits) anhand des zumindest einen Indikators ermittelt werden kann, so dass der ermittelte Störungsgrad bei der Kanaldecodierung der kanalcodierten Nutzdaten berücksichtigt werden kann, um eine Effektivität der Kanaldecodierung zu steigern.

Weitere Ausführungsbeispiele schaffen ein System, mit einem Datenempfänger und einem Datensender. Der Datenempfänger umfasst eine Einrichtung zum Empfangen von Datenpaketen, die ausgebildet ist, um das zumindest eine Datenpaket zu empfangen, wobei das zumindest eine Datenpaket kanalkodierte Nutzdaten und zumindest einen Indikator aufweist, wobei die Einrichtung zum Empfangen von Datenpaketen ausgebildet ist, um für das zumindest eine empfangene Datenpaket empfangene Daten, die die empfangenen kanalkodierten Nutzdaten und den zumindest einen empfangenen Indikator umfassen, auszugeben. Ferner umfasst der Datenempfänger eine Einrichtung zum Weiterverarbeiten von empfangenen Daten, die ausgebildet ist, um aus den empfangenden Daten die empfangenen kanalkodierten Nutzdaten und den zumindest einen empfangenen Indikator zu ermitteln, und um den zumindest einen empfangenen Indikator des zumindest einen empfangenen Datenpaketes mit zumindest einem Referenzindikator, der dem Datensender und Datenempfänger bekannt ist, zu vergleichen, und um basierend auf dem Vergleich zwischen dem zumindest einen empfangenen Indikator und dem zumindest einen Referenzindikator zumindest einen Störungsgrad der empfangenen kanalcodierten Nutzdaten des zumindest einen empfangenen Datenpaketes zu ermitteln. Die Einrichtung zum Weiterverarbeiten von empfangenen Daten ist dabei ausgebildet, um die empfangenen kanalcodierten Nutzdaten des zumindest einen empfangenen Datenpakets basierend auf dem ermittelten zumindest einen Störungsgrad für eine Decodierung zu gewichten, und um eine von der Gewichtung der empfangenen kanalcodierten Nutzdaten abhängige Kanaldecodierung durchzuführen, um die Nutzdaten zu erhalten. Der Datensender ist ausgebildet, um das Datenpaket mit den kanalcodierten Nutzdaten und dem zumindest einen Indikator zu dem Datenempfänger über den Kommunikationskanal zu senden.

Weitere Ausführungsbeispiele schaffen ein Verfahren zum Empfangen von Nutzdaten, die von einem Datensender mittels zumindest eines Datenpakets über einen Kommunikationskanal gesendet werden. Das Verfahren umfasst:
- Empfangen des zumindest eine Datenpakets, wobei das zumindest eine Datenpaket kanalkodierte Nutzdaten und zumindest einen Indikator aufweist;
- Bereitstellen von empfangene Daten für das zumindest eine empfangene Datenpaket, wobei die empfangenen Daten die empfangenen kanalkodierten Nutzdaten und den zumindest einen empfangenen Indikator umfassen;
- Ermitteln der empfangenen kanalcodierten Nutzdaten und des zumindest einen empfangene Indikators aus den empfangenden Daten;
- Vergleichen des zumindest einen empfangene Indikators des zumindest einen empfangenen Datenpaketes mit zumindest einem Referenzindikator, der dem Datensender und Datenempfänger bekannt ist, um basierend auf dem Vergleich zwischen dem zumindest einen empfangenen Indikator und dem zumindest einen Referenzindikator zumindest einen Störungsgrad der empfangenen kanalcodierten Nutzdaten des zumindest einen empfangenen Datenpaketes zu ermitteln;
- Gewichten der empfangenen kanalcodierten Nutzdaten des zumindest einen empfangenen Datenpakets für eine Decodierung basierend auf dem ermittelten zumindest einen Störungsgrad; und
- Durchführung einer von der Gewichtung der empfangenen kanalcodierten Nutzdaten abhängigen Kanaldecodierung, um die Nutzdaten zu erhalten.

Ausführungsbeispiele der vorliegenden Erfindung werden bezugnehmend auf die beiliegenden Figuren näher erläutert. Es zeigen:
- Fig. 1: ein schematisches Blockschaltbild eines Datenempfängers, gemäß einem Ausführungsbeispiel der vorliegenden Erfindung;
- Fig. 2: ein schematisches Blockschaltbild eines Datenempfängers, gemäß einem weiteren Ausführungsbeispiel der vorliegenden Erfindung;
- Fig. 3a: eine schematische Ansicht eines von einem Datensender gesendeten Datenpaketes, gemäß einem Ausführungsbeispiel der vorliegenden Erfindung;
- Fig. 3b: eine schematische Ansicht einer von dem Datenempfänger empfangenen Version des Datenpakets, wenn das in Fig. 3a gezeigte Datenpaket von dem Datensender über einen gestörten Kommunikationskanal gesendet wird, gemäß einem Ausführungsbeispiel der vorliegenden Erfindung;
- Fig. 3c: eine schematische Ansicht einer von dem Datenempfänger empfangenen Version des Datenpakets, wenn das in Fig. 3a gezeigte Datenpaket von dem Datensender über einen gestörten Kommunikationskanal gesendet wird, gemäß einem Ausführungsbeispiel der vorliegenden Erfindung;
- Fig. 4: ein schematisches Blockschaltbild eines Systems mit einem Datensender und einem Datenempfänger, gemäß einem Ausführungsbeispiel der vorliegenden Erfindung;
- Fig. 5: in einem Diagramm eine Kanalaktivität bei der Übertragung eines Datenpakets und in einem Diagramm einen Energieverbrauch des Empfängers beim Empfang des Datenpakets, jeweils aufgetragen über die Zeit;
- Fig. 6: ein schematisches Flussdiagramm eines Verfahrens zur Erzeugung von Datenpaketen, gemäß einem Ausführungsbeispiel der vorliegenden Erfindung; und
- Fig. 7: ein Flussdiagramm eines Verfahrens zum Empfangen von Nutzdaten, die von einem Datensender mittels zumindest eines Datenpakets über einen Kommunikationskanal gesendet werden, gemäß einem Ausführungsbeispiel der vorliegenden Erfindung.

In der nachfolgenden Beschreibung der Ausführungsbeispiele der Erfindung werden in den Figuren gleiche oder gleichwirkende Elemente mit den gleichen Bezugszeichen versehen, so dass deren Beschreibung in den unterschiedlichen Ausführungsbeispielen untereinander austauschbar ist.

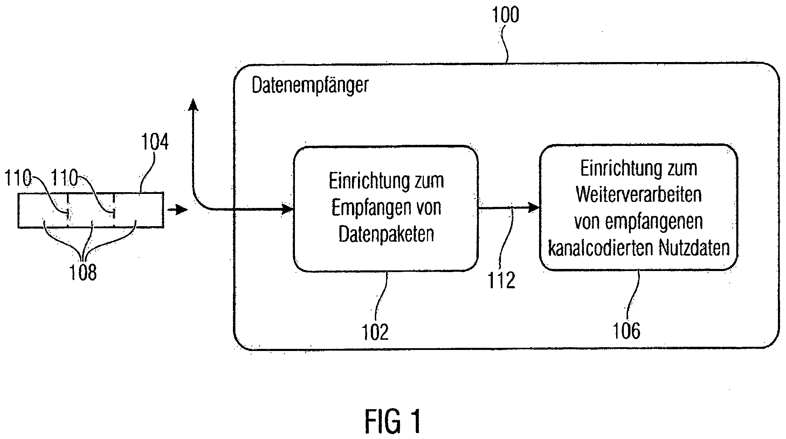

Fig. 1 zeigt ein schematisches Blockschaltbild eines Datenempfängers 100 gemäß einem Ausführungsbeispiel der vorliegenden Erfindung. Der Datenempfänger 100 umfasst eine Einrichtung 102 zum Empfangen von Datenpaketen 104 und eine Einrichtung 106 zum Weiterverarbeiten von empfangenen Daten.

Die Einrichtung 102 zum Empfangen von Datenpaketen 104 ist ausgebildet, um das zumindest eine Datenpaket 104 zu empfangen, wobei das zumindest eine Datenpaket 104 kanalkodierte Nutzdaten 108 und zumindest einen Indikator 110 aufweist, wobei die Einrichtung 102 zum Empfangen von Datenpaketen 104 ausgebildet ist, um für das zumindest eine empfangene Datenpaket 104 empfangene Daten 112, die die empfangenen kanalkodierten Nutzdaten 108 und den zumindest einen empfangenen Indikator 110 umfassen, auszugeben.

Bei Ausführungsbeispielen kann die Einrichtung 102 zum Empfangen von Datenpaketen 104 ausgebildet sein, um die empfangenen Daten 112 in Form von bereits entschiedenen Bits auszugeben. Ferner kann die Einrichtung 102 zum Empfangen von Datenpaketen 104 so ausgebildet sein (z.B. so einfach aufgebaut sein), dass diese auf Symbolebene keine Information über eine Qualität der empfangenen Daten 112 ausgeben kann. Somit ist keine Qualitätsschätzung auf Symbolebene (Datensymbolebene) basierend auf den von der Einrichtung 102 zum Empfangen von Datenpaketen 104 bereitgestellten Daten/Informationen möglich. Des Weiteren kann die Einrichtung zum Empfangen von Datenpaketen 104 so ausgebildet sein (z.B. so einfach aufgebaut sein), dass diese nicht zwischen den empfangenen kanalcodierten Nutzdaten 108 und dem zumindest einen empfangen Indikator 110 unterscheiden kann.

Beispielsweise kann die Einrichtung 102 zum Empfangen von Datenpaketen 104 ein einfacher oder kostengünstiger Empfängerchip (oder Receiverchip, oder Transceiverchip) sein, der an seinem Ausgang die empfangenen Daten 112 in Form von bereits entschiedenen Bits oder als bereits demodulierte digitale Bitfolge (=entschiedene Bits) bereitstellt. Aufgrund des einfachen Aufbaus fehlt es dem Empfängerchip an Fähigkeiten Informationen über eine Qualität eines Kanals oder der empfangenen Daten 112 zu ermitteln. Auch bietet der Empfängerchip keine Möglichkeit die Informationen, die zur Berechnung der Qualität des Kanals oder der empfangenen Daten 112 notwendig wären, einem anderen Chip bereitzustellen.

Die Einrichtung 106 zum Weiterverarbeiten von empfangenen Daten 112 ist, ausgebildet, um aus den empfangenden Daten 112, die empfangenen kanalkodierten Nutzdaten 108 und den zumindest einen empfangenen Indikator 110 zu ermitteln, und um den zumindest einen empfangenen Indikator 110 des zumindest einen empfangenen Datenpaketes 104 mit zumindest einem Referenzindikator, der dem Datensender und Datenempfänger 100 bekannt ist, zu vergleichen, und um basierend auf dem Vergleich zwischen dem zumindest einen empfangenen Indikator 110 und dem zumindest einen Referenzindikator zumindest einen Störungsgrad der empfangenen kanalcodierten Nutzdaten 108 des zumindest einen empfangenen Datenpaketes 104 zu ermitteln.

Die Einrichtung 106 zum Weiterverarbeiten von empfangenen Daten 112 ist dabei ausgebildet, um die empfangenen kanalcodierten Nutzdaten 108 des zumindest einen empfangenen Datenpakets 104 basierend auf dem ermittelten zumindest einen Störungsgrad für eine Decodierung zu gewichten, und um eine von der Gewichtung der empfangenen kanalcodierten Nutzdaten 108 abhängige Kanaldecodierung durchzuführen, um die Nutzdaten zu erhalten.

Bei Ausführungsbeispielen kann die Einrichtung 106 zum Weiterverarbeiten von empfangenen Daten 112 somit noch vor der Kanaldecodierung der empfangen kanalcodierten Nutzdaten einen Störungsgrad der empfangenen kanalcodierten Nutzdaten 108 anhand des zumindest einen empfangen Indikators 110 ermitteln und den ermittelten Störungsgrad bei der Kanaldecodierung der empfangen kanalcodierten Nutzdaten berücksichtigen. Dadurch, dass der Störungsgrad der empfangen kanalcodierten Nutzdaten bei der Kanaldecodierung der empfangen kanalcodierten Nutzdaten berücksichtigt wird, kann eine Qualität der Decodierung (Kanaldecodierung) verbessert werden.

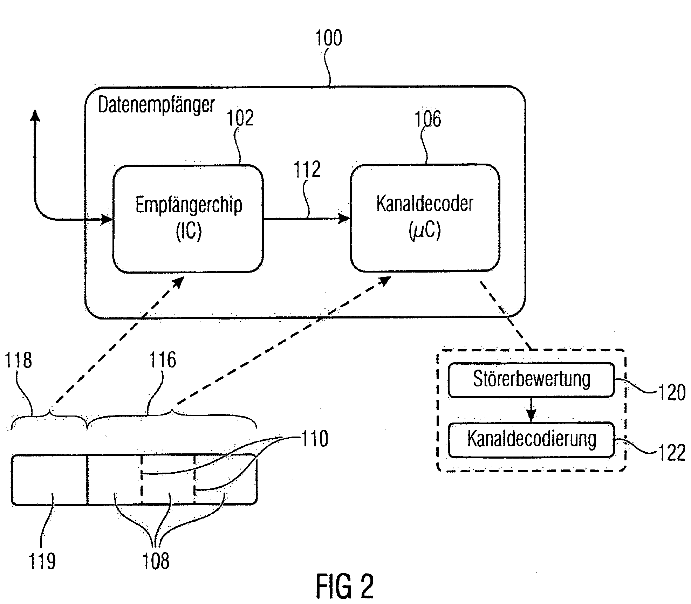

Fig. 2 zeigt ein schematisches Blockschaltbild eines Datenempfängers 100 gemäß einem weiteren Ausführungsbeispiel der vorliegenden Erfindung. Der Datenempfänger 100 umfasst eine Einrichtung 102 zum Empfangen von Datenpaketen 104 und eine Einrichtung 106 zum Weiterverarbeiten von empfangenen Daten 112.

Wie oben bereits erwähnt und in Fig. 2 gezeigt ist, kann die Einrichtung 102 zum Empfangen von Datenpaketen 104 ein (einfacher, kostengünstiger) Empfängerchip (z.B. ein IC (IC = Integrated Circuit, dt. integrierter Schaltkreis)) sein, während die Einrichtung 106 zum Weiterverarbeiten von empfangenen Daten 112 ein Decoder oder Kanaldecoder (z.B. ein µC (µC = Microcontroller, dt. Mikrocontroller)) sein kann.

Wie in Fig. 2 ferner gezeigt ist, kann das Datenpaket 104 einen Nutzdatenbereich 116 und optional einen Kontrolldatenbereich 118 aufweisen. Der Kontrolldatenbereich befindet sich nicht notwendigerweise am Anfang des Datenpakets 104, sondern kann an einer beliebigen Position platziert werden.

Der Kontrolldatenbereich 118 kann beispielsweise eine Synchronisationssequenz (oder Präambel) 119 enthalten, wobei die Einrichtung 102 zum Empfangen von Datenpaketen 104 ausgebildet sein kann, um eine Synchronisation (oder eine Frequenzschätzung) des Datenpaketes 104 unter Verwendung der Synchronisationssequenz 119 durchzuführen. Natürlich kann die Einrichtung 102 zum Empfangen von Datenpaketen 104 auch ausgebildet sein, um ein Datenpaket 104 ohne Kontrolldatenbereich 118, d.h. ohne Synchronisationssequenz 119, zu empfangen. Beispielsweise kann dem Datenempfänger 100 der Zeitpunkt des Eintreffens des Datenpakets 104 bekannt sein, wodurch es dem Datenempfänger 100 möglich ist, das Datenpaket 104 aus einem Empfangsdatenstrom zu dem bekannten Zeitpunkt zu ermitteln.

Ferner kann der Kontrolldatenbereich 118 eine Präambel enthalten. Die Einrichtung 102 zum Empfangen von Datenpaketen 104 ist dabei so ausgebildet ist, dass diese die in dem Kontrolldatenbereich 118 enthaltene Daten nicht ausgibt.

Der Nutzdatenbereich 116 kann als Daten die Nutzdaten 108 und den zumindest einen Indikator 110 enthalten. Die Einrichtung 102 zum Empfangen von Datenpaketen 104 kann dabei ausgebildet sein, um die in dem Nutzdatenbereich 116 enthaltenen Daten als empfangene Daten 112 (in Form von bereits entschiedenen Bits bzw. als demodulierte Bitfolge) auszugeben.

Der in dem Datenpaket 104 enthaltene zumindest eine Indikator 110 wird somit von der Einrichtung 102 zum Empfangen von Datenpaketen 104 nur zusammen mit den Nutzdaten 108 als empfangene Daten 112 ausgegeben und nicht zum Empfangen des Datenpakets 104 verwendet, z.B. zur Durchführung einer Synchronisation (des Datenpakets 104) basierend auf dem zumindest einen Indikator 110 oder unter Verwendung des zumindest einen Indikators 110. Sofern das Datenpaket 104 den optionalen Kontrolldatenbereich 118 mit einer Synchronisationssequenz 119 enthält, kann die Einrichtung 102 zum Empfangen von Datenpaketen 104 den Kontrolldatenbereich 118 zum Empfangen des Datenpakets 104 nutzen, beispielsweise zur Synchronisation des Datenpakets 104 unter Verwendung der in dem Kontrolldatenbereich 118 enthaltenen Synchronisationssequenz 119. Die Einrichtung 102 zum Empfangen von Datenpaketen gibt jedoch die Synchronisationssequenz 119 (oder eine andere in dem Kontrolldatenbereich enthaltene Information) nicht aus, so dass die Einrichtung 106 zum Weiterverarbeiten von empfangene Daten 112 keine Information von der Einrichtung 102 zum Empfangen von Datenpaketen über die Qualität der empfangen Daten 112 erhält.

Vielmehr bestimmt die Einrichtung 106 zum Weiterverarbeiten von empfangen Daten 112, wie oben bereits beschrieben, noch vor der Decodierung der empfangen kanalcodierten Nutzdaten 108 einen Störungsgrad der empfangenen kanalcodierten Nutzdaten 108 anhand des zumindest einen empfangen Indikators 110 und verwendet den ermittelten Störungsgrad bei der Decodierung der empfangen kanalcodierten Nutzdaten. Beispielsweise kann die Einrichtung 106 zum Weiterverarbeiten von empfangen Daten 112 ausgebildet sein, um basierend auf dem zumindest einen empfangen Indikator 110 eine Störerbewertung 120 und eine Kanaldecodierung 122 durchzuführen.

Dadurch, dass der Störungsgrad der empfangen kanalcodierten Nutzdaten bei der Decodierung der empfangen kanalcodierten Nutzdaten berücksichtigt wird, kann eine Qualität der Decodierung (Kanaldecodierung) verbessert werden, wie im Folgenden ausgeführt wird.

Für Fehlerschutzcodes ist sehr vorteilhaft, wenn bekannt ist, ob und wie stark empfangene Symbole gestört sind (Hinweis: Siehe auch bisher unveröffentlichtes, beiliegendes Paper). Die gestörte Information in den Symbolen zu verwerfen kann (viel) besser sein, als diese zu verwenden. In der Nachrichtentechnik gibt es hier die Beschreibung in LogLikelihoodRatios (dt. Likelihood-Quotienten-Test), die die Sicherheit von Information angibt.

Fehlerschutzcodes, wie z.B. Faltungscodes, Reed-Solomon-Codes oder auch Turbocodes, können Empfangspakete mit einer größeren Menge fehlender oder falscher Symbole wiederherstellen, wenn bekannt ist, welche Symbole gestört wurden, als mit gestörten Symbolen, bei denen nicht bekannt ist, dass eine Störung vorlag.

Um zu ermitteln, wie sicher die empfangenen Informationen sind, können dem Datenpaket 104 bei Ausführungsbeispielen Indikatoren 110 hinzugefügt werden. Ein Indikator 100 kann hierbei aus einem einzelnen oder mehreren Indikatorsymbolen bestehen. Die Indikatoren und deren Verteilung in einem Datenpaket (oder Hop) 104 sind dem Sender und Empfänger vor der Kommunikation bekannt.

Ein einzelnes Indikatorsymbol kann einem Symbol des verwendeten Modulationsverfahrens entsprechen. Der Datenempfänger 100 kann die empfangenen Symbole der Indikatoren 110 mit dem erwarteten Muster vergleichen und basierend auf der Differenz die Qualität des empfangenen Datenpakets (Hops) bzw. Teildatenpakets (Teil des Hops) ermitteln. Für diese Qualitätsbeurteilung sind die Auswahl der Indikatorsymbole und deren Verteilung von (erheblicher) Bedeutung.

Die optimale Verteilung der Indikatoren 110 richtet sich vornehmlich nach der Länge der erwarteten Störer, dem verwendeten Algorithmus zur Sicherheitsbestimmung sowie der geforderten Empfangssicherheit. Beim Aufbau der Indikatoren 110 ist es vorteilhaft unterschiedliche Modulationssymbole als Indikatorsymbole zu wählen, da es sonst aufgrund des einfachen Empfangschips 102, der nur entschiedene, demodulierte Symbole zurückliefert, nicht möglich ist, Störer in mehreren Dimensionen zu erfassen.

Eine einfache Illustration hierzu ist eine binäre Amplitudenmodulation. Werden nur High-Pegel (hoch Pegel) als Indikatorsymbole verwendet, werden diese bei einem konstanten lauten Störer immer korrekt empfangen, und die Indikatoren 110 als fehlerfrei deklariert, wodurch die Zuverlässigkeit der Empfangssymbole als hoch angenommen wird, obwohl die in den Informationssymbolen vorkommenden Low-Pegel (niedrig Pegel) ebenso gestört als High-Pegel (hoch Pegel) empfangen werden.

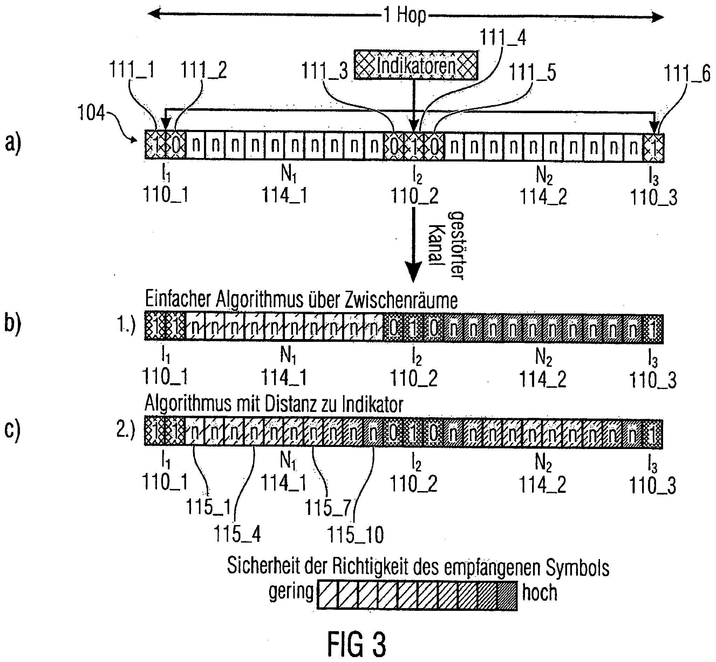

Fig. 3a zeigt eine schematische Ansicht eines von einem Datensender gesendeten Datenpaketes 104. Wie in Fig. 3a zu erkennen ist, kann das Datenpaket 104 mehrere Indikatoren 110 aufweisen, die gemäß ihrem zeitlichen Auftreten in dem Datenpaket 104 verteilt angeordnet sind. Ein Indikator 110 kann dabei zumindest ein Indikatorsymbol 111 umfassen, wobei ein Indikatorsymbol 111 ein Symbol eines zur Übertragung des zumindest einen Datenpakets 104 verwendeten Modulationsverfahrens ist oder diesem entspricht.

Wie bereits erwähnt wurde, werden die Indikatoren 110 nicht zur Synchronisation oder Frequenzschätzung von der Einrichtung 102 zum Empfangen von Datenpaketen genutzt, sondern von der Einrichtung 106 zum Weiterverarbeiten von empfangen Daten 112 zur Bestimmung des Störungsgrads der in dem Datenpaket 104 enthaltenen kanalcodierten Nutzdaten, welcher anschließend bei der Kanaldecodierung berücksichtigt wird. Daher genügt es wenn 30 % oder weniger der zur Übertragung des Datenpakets 104 verwendeten Symbole des Modulationsverfahrens Indikatorsymbole sind. Ferner genügt es wenn in dem Datenpaket 104 höchstens vier Indikatorsymbole gemäß ihrem zeitlichen Auftreten unmittelbar aufeinanderfolgend angeordnet sind.

Das in Fig. 3a gezeigte Datenpaket 104 weist beispielhaft drei Indikatoren 110_1 bis 110_3 auf, wobei die Indikatoren 110_1 bis 110_3 in dem Datenpaket 104 verteilt angeordnet sind. Zwischen dem ersten Indikator 110_1 und dem zweiten Indikator 110_2 ist ein erster Block von Nutzdaten 114_1 angeordnet, während zwischen dem zweiten Indikator 110_2 und dem dritten Indikator 110_3 ein zweiter Block von Nutzdaten 114_2 angeordnet ist. Ferner weist ein erster Indikator 110_1 der drei Indikatoren 110_1 bis 110_3 zwei Indikatorsymbole 111_1 und 111_2 auf, wobei ein zweiter Indikator 110_2 der drei Indikatoren 110_1 bis 110_3 drei Indikatorsymbole 111_3 bis 111_5 aufweist, und wobei ein dritter Indikator 110_3 der drei Indikatoren 110_1 bis 110_3 ein Indikatorsymbol 111_6 aufweist.

Mit anderen Worten, in Fig. 3a ist gezeigt wie ein Datenpaket (Hop) 104 mit Indikatoren 110 aufgebaut sein kann, wenn eine binäre Modulation verwendet wird. Es ist anzumerken dass die Indikatoren 110_1 bis 110_3 nicht notwendigerweise am Anfang und Ende des Datenpakets (Hops) 104 zu finden sind. Die optimale Position, Länge und Anzahl der Indikatoren ist immer Gegenstand der Optimierung an die äußeren und vom System gegebenen Parameter.

Fig. 3b zeigt eine schematische Ansicht einer von dem Datenempfänger 100 empfangenen Version des Datenpakets 104, wenn das in Fig. 3a gezeigte Datenpaket 104 von dem Datensender über einen gestörten Kommunikationskanal gesendet wird. Wie in Fig. 3b zu erkennen ist, wurde von dem ersten Indikator 110_1 das zweite Indikatorsymbol 111_2 gestört.

Die Einrichtung 106 zum Weiterverarbeiten von empfangen Daten 112 ist ausgebildet, um die empfangenen Indikatoren 110_1 bis 110_3 mit Referenzindikatoren zu vergleichen, und um basierend auf dem Vergleich einen Störungsgrad der empfangenen kanalcodierten Nutzdaten zu ermitteln, und um die empfangenen kanalcodierten Nutzdaten basierend auf dem ermittelten Störungsgrad für eine Decodierung zu gewichten.

In dem in Fig. 3a und 3b gezeigten Fall würde der Vergleich zwischen den Indikatoren 110_1 bis 110_3 entsprechend ergeben, dass das zweite Indikatorsymbol 111_2 des ersten Indikators 110_1 gestört ist, während die übrigen Indikatorsymbole nicht gestört sind.

Gemäß einem Ausführungsbeispiel kann die Einrichtung 106 zum Weiterverarbeiten von empfangen Daten 112 basierend auf dem Vergleich beispielsweise einen (einheitlichen) Störungsgrad für die Nutzdaten, die (jeweils) zwischen den Indikatoren, angeordnet sind, ermitteln, wobei der Störungsgrad beispielsweise zwei unterschiedliche Werte annehmen kann, gestört und ungestört. Die ungestörten Nutzdaten können bei der anschließenden Kanaldecodierung stärker gewichtet werden als die gestörten Nutzdaten. Beispielsweise können bei der Kanaldecodierung nur die ungestörten Nutzdaten berücksichtigt werden, während die gestörten Nutzdaten verworfen werden. Natürlich können auch andere Gewichtungsfaktoren verwendet werden. Zum Beispiel können die ungestörten Nutzdaten mit einem Faktor kleiner eins (z.B. 0,8) in die Kanaldecodierung einfließen, während die gestörten Nutzdaten mit einem Faktor größer null (z.B. 0,2) in die Kanaldecodierung einfließen können, wobei ein Faktor von eins einer vollständigen Berücksichtigung der entsprechenden Nutzdaten entspricht, und wobei ein Faktor von null dem Verwerfen der entsprechenden Nutzdaten entspricht,

In dem in Fig. 3a und 3b gezeigten Fall kann die Einrichtung 106 zum Weiterverarbeiten von empfangen Daten 112 beispielsweise ermitteln, dass der erste Block von Nutzdaten 114_1 zwischen dem ersten Indikator 110_1 und dem zweiten Indikator 110_2 gestört ist, während der zweite Block von Nutzdaten 114_2 zwischen dem zweiten Indikator 110_2 und dem dritten Indikator 110_3 ungestört ist, so dass beispielsweise nur der zweite Block von Nutzdaten 114_2 bei der Kanaldecodierung berücksichtigt wird, während der erste Block von Nutzdaten 114_1 verworfen wird.

Nach dem Empfang eines Datenpakets (Hops) 104, können die empfangenen Nutzdatensymbole somit anhand der Fehler in den empfangenen Indikatoren 110_1 bis 110_3 bewertet werden und die Sicherheit des richtigen Empfangs eines jeden Symbols definiert werden bevor die Daten der Kanaldecodierung übergeben werden. Die Indikatoren 110 sind somit nicht Bestandteil der Kanalcodierung. Die Gewichtung der Sicherheit kann beliebig einfach oder komplex gestaltet werden.

Als einfaches Beispiel für so ein Verfahren bietet sich die Unterscheidung zwischen "ungestört - mit gegebener Sicherheit" und "gestört - unsicher" an. Hierbei werden die Symbole anhand der angrenzenden Indikatoren in die entsprechende Kategorie einsortiert (vgl. Fig. 3b).

Soll mit diesem Verfahren auch der kürzeste erwartete Störer erkannt werden, so darf die Dauer zwischen zwei Indikatoren nicht länger sein als dieser Störer, da es sonst passieren kann, dass die Indikatoren 110_1 bis 110_3 ungestört übertragen werden, die Informationssymbole 114_1 und 114_2 zwischen den Indikatoren 110_1 bis 110_3 jedoch gestört wurden. Hierdurch würde die Gewichtung der Symbole die Leistungsfähigkeit des Fehlerschutzcodes negativ beeinflussen.

Fig. 3c zeigt eine schematische Ansicht einer von dem Datenempfänger 100 empfangenen Version des Datenpakets 104, wenn das in Fig. 3a gezeigte Datenpaket von dem Datensender über einen gestörten Kommunikationskanal gesendet wird. Wie auch bei Fig. 3b wurde von dem ersten Indikator 110_1 das zweite Indikatorsymbol 111_2 gestört.

Bei diesem Ausführungsbeispiel kann die Einrichtung 106 zum Weiterverarbeiten von empfangenen Daten 112 jedoch ausgebildet sein, um einen Störungsgrad eines Teils der Nutzdaten, der in dem Datenpaket 104 einen geringeren (zeitlichen) Abstand zu einem der zumindest zwei voneinander beabstandeten Indikatoren aufweist, stärker in Abhängigkeit des Vergleichs des einen Indikators mit dem entsprechenden Referenzindikator zu ermitteln, als ein Teil der Nutzdaten, der in dem zumindest einen Datenpaket einen größeren (zeitlichen) Abstand zu dem einen Indikator aufweist.

In dem in Fig. 3a und 3c gezeigten Fall würde der Vergleich zwischen den Indikatoren 110_1 bis 110_3 entsprechend ergeben, dass das zweite Indikatorsymbol 111_2 des ersten Indikators 110_1 gestört ist, während die übrigen Indikatorsymbole nicht gestört sind.

Dementsprechend würde die Einrichtung 106 zum Weiterverarbeiten von empfangenen Daten 112 für die Nutzdatensymbole (z.B. das Nutzdatensymbol 115_1), die einen zeitlich geringeren Abstand zu dem gestörten, ersten Indikator 110_1 aufweisen, einen höheren Störungsgrad ermitteln als für Nutzdatensymbole (z.B. das Nutzdatensymbol 115_4, oder 115_7, oder 115_10) die einen zeitlich höheren Abstand zu dem gestörten, ersten Indikator 110_1 aufweisen bzw. einen zeitlich geringeren Abstand zu dem ungestörten, zweiten Indikator 110_2 aufweisen.

Die unterschiedlichen Störungsgrade der Nutzdatensymbole von gering (z.B. für das Nutzdatensymbol 115_10) bis hoch (z.B. für das Nutzdatensymbol 115_1) sind in Fig. 3c durch die unterschiedlichen Farben/Schraffierungen dargestellt.

Wie in Fig. 3c zu erkennen ist, kann die Einrichtung 106 zum Weiterverarbeiten von empfangenen Daten 112 ausgebildet sein, um mehrere (zumindest drei) unterschiedliche Störungsgrade anhand der Indikatoren zu ermitteln. Ferner kann die Einrichtung 106 zum Weiterverarbeiten von empfangenen Daten ausgebildet sein, um mehrere (zumindest drei) unterschiedliche Gewichtungsstufen oder Gewichtungsfaktoren basierend auf den mehreren unterschiedlichen Störungsgraden zu ermitteln.

Mit anderen Worten, komplexere Verfahren können die Fehlermuster in den Indikatoren analysieren und die Sicherheit der einzelnen Nutzsymbole anhand derer individuell anpassen. Ist ein Indikator gestört und der darauffolgende nicht, so ließe sich die Sicherheit eines Nutzsymbols z.B. anhand seiner zeitlichen Nähe zum gestörten Indikator festlegen (vgl. Fig. 3c). Mit diesem Verfahren ist es nicht notwendig, die Indikatoren so nahe zusammen zu setzen, dass der kürzeste Störer erkannt wird, da die Symbole die potentiell gestört sein können schon eine geringere Sicherheit zugewiesen bekommen haben. Die optimale Länge und Verteilung der Indikatoren ist hierbei ein Optimierungsproblem, das speziell auf das gegebene Szenario angepasst wird.

Ermittelt der Empfänger z.B. durch das analysieren der Prüfsummen, das trotz der Optimierung eine hohe Fehlerrate auftritt so kann er adaptiv die Funktion zur Gewichtung der Symbole anpassen. Dies ermöglicht es dem Empfangsknoten die Übertragung auf seine tatsächliche Umgebung anzupassen.

Verfügt der Empfangschip über die Möglichkeit die empfangene Signalleistung eines Hops zu ermitteln (z.B. über RSSI Messung (RSSi = Received Signal Strengh Indikation, dt. ein Indikator für die Empfangsfeldstärke kabelloser Kommunikationsanwendungen)), so kann diese aufgezeichnet werden und der Verlauf der Leistungen über eine oder mehrere Nachrichten gespeichert werden. Bei Hops bei denen die Empfangsleistung signifikant von vorherigen Messungen abweicht, ist es wahrscheinlich, dass ein Störer aktiv war oder das Signal gedämpft wurde und die Sicherheit der Richtigkeit der empfangenen Symbole dieses Hops kann entsprechend korrigiert werden.

Fig. 3a bis 3c zeigen somit Datenpakete mit drei Indikatoren unterschiedlicher Länge, Nutzsymbole n in zwei Nutzdatenblöcken 114_1 (N₁) und 114_2 (N₂) vor (Fig. 3a) und nach (Fig. 3b und 3c) dem Übertragen über den gestörten Kanal. In Fig. 3b ist 114_1 (N₁) als gestört markiert da Indikator 110_1 (I₁) gestört ist, während 114_2 (N₂) ungestört markiert ist, da 110_2 (I₂) und 110_3 (I₃) ungestört sind. In Fig. 3c weist der Anfang von 114_1 (N₁) eine geringe Sicherheit auf, da der Anfang nahe an dem gestörten Indikator 110_1 (I₁) liegt. Das Ende von 114_1 (N₁) weist hingegen eine höhere Sicherheit auf, da das Ende näher am ungestörten Indikator 110_2 (I₂) liegt. Die Mitte von 114_2 (N₂) weist eine geringere Sicherheit aufgrund des größeren Abstandes zu den ungestörten Indikatoren 110_2 (I₂) und 110_3 (I₃) auf.

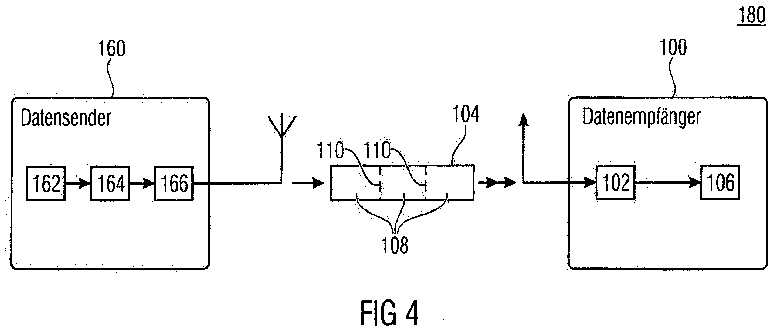

Fig. 4 zeigt ein schematisches Blockschaltbild eines Systems 180 mit einem Datensender 160 und dem oben beschriebenen Datenempfänger 100, gemäß einem Ausführungsbeispiel der vorliegenden Erfindung.

Der Datensender 160 kann ausgebildet sein, um das Datenpaket 104 mit den kanalcodierten Nutzdaten 108 und dem zumindest einen Indikator 110 zu dem Datenempfänger 100 über den Kommunikationskanal zu senden.

Im Detail kann der Datensender 160 eine Einrichtung 162 zum Kanalcodieren von Nutzdaten aufweisen, die ausgebildet ist, um die Nutzdaten kanal zu codieren, um kanalcodierte Nutzdaten zu erhalten. Ferner kann der Datensender 100 eine Einrichtung 164 zum Erzeugen von Datenpaketen aufweisen, die ausgebildet ist, um zumindest ein Datenpaket (z.B. zumindest zwei Datenpakete beim Paketaufteilungsverfahren) aus den kanalcodierten Nutzdaten zu erzeugen. Die Einrichtung 164 zum Erzeugen von Datenpaketen kann dabei ausgebildet sein, um die kanalcodierten Nutzdaten (in dem Datenpaket) mit zumindest einem Indikator, der dem Datensender 160 und Datenempfänger 100 bekannt ist, zu versehen. Ferner kann der Datensender 160 eine Einrichtung 166 zum Senden von Datenpaketen aufweisen, die ausgebildet ist, um das zumindest eine Datenpaket 104 über den Kommunikationskanal zu dem Datenempfänger 100 zu senden.

Bei Ausführungsbeispielen kann der Datensender 160 beispielsweise eine Basisstation sein, während der Datenempfänger 100 ein Knoten ist. Natürlich kann auch der Datensender 160 der Knoten sein, während der Datenempfänger 100 die Basisstation ist.

Im Folgenden werden Ausführungsbeispiele zur Energieverbrauchsminimierung beschrieben.

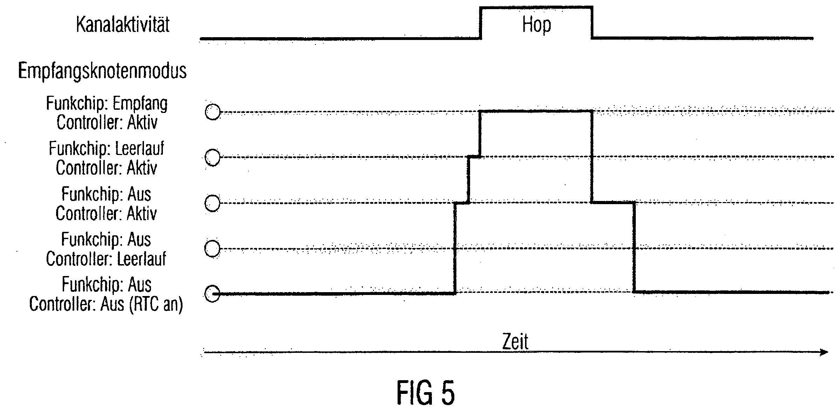

Um neben der Robustheit der Verbindung auch den Stromverbrauch zu minimieren, kann eine Übertragung zu einem festgelegten Zeitpunkt auf einer festgelegten Frequenz verwendet werden. Hierdurch ist es dem Empfänger 100 möglich den Empfangschip 102 so kurz wie möglich im aktiven Empfangsmodus zu betreiben und auch alle anderen Komponenten zu deaktivieren, solange ein aufwachen zu einem fixen Zeitpunkt gewährleistet ist (Energiesparmodus (engl. Low Power Mode) mit aktivem Timer oder aktivierter Echtzeituhr (engl. Real Time Clock), siehe Fig. 5.

In Detail zeigt Fig. 5 in einem Diagramm eine kanalaktivität bei der Übertragung eines Datenpakets (Hops) 104 und in einem Diagramm einen Energieverbrauch des Empfängers 100 beim Empfang des Datenpakets 104, jeweils aufgetragen über die Zeit.

Wie in Fig. 5 zu erkennen ist, befindet sich der Datenempfänger 100 zu einem ersten Zeitpunkt (vor dem Empfang des Datenpakets) in einem ersten Betriebsmodus (oder Betriebszustand), bei dem sowohl der Funkchip 102 als auch der Controller 106 deaktiviert (ausgeschaltet) sind. Zu einem zweiten Zeitpunkt befindet sich der Datenempfänger 100 in einem zweiten Betriebsmodus, bei dem sich der Controller 106 im Leerlauf befindet, während der Funkchip 102 deaktiviert ist. Zu einem dritten Zeitpunkt (der mit dem zweiten Zeitpunkt zusammenfallen kann) befindet sich der Datenempfänger 100 in einem dritten Betriebsmodus, bei dem Controller 106 aktiviert ist, während der Funkchip 102 deaktiviert ist. Zu einem vierten Zeitpunkt befindet sich der Datenempfänger 100 in einem vierten Betriebsmodus, bei dem der Controller 106 aktiv ist, während der Funkchip 102 im Leerlauf ist. Zu einem fünften Zeitpunkt (zum Zeitpunkt des Empfangs des Datenpakets) befindet sich der Datenempfänger 100 in einem fünften Betriebsmodus, bei Controller 106 aktiv ist und der Funkchip 102 das Datenpaket 104 empfängt.

Zu einem sechsten Zeitpunkt (nach dem Empfang des Datenpakets 104) befindet sich der Datenempfänger 100 in dem vierten Betriebsmodus. Zu einem siebten Zeitpunkt (der mit dem sechsten Zeitpunkt zusammenfallen kann, d.h. der vierte Betriebsmodus wird übersprungen) befindet sich der Datenempfänger 100 in dem dritten Betriebsmodus. Zu einem achten Zeitpunkt befindet sich der Datenempfänger in dem zweiten Betriebsmodus. Zu einem neunten Zeitpunkt (der mit dem achten Zeitpunkt zusammenfallen kann, d.h. der zweite Betriebsmodus wird übersprungen) befindet sich der Datenempfänger in dem ersten Betriebsmodus.

Mit anderen Worten, Fig. 5 zeigt einen beispielhaften Verlauf der möglichen Modi des Empfangsknotens 100 beim Empfang eines Datenpakets (Hops) 104. Die Echtzeituhr kann den Controller 106 zum exakten Zeitpunkt aufwecken, um den Funkchip 102 zur vordefinierten Zeit auf Empfang zu schalten. Aktivität des Controllers 106 nach Empfang zum Verarbeiten der empfangenen Symbole.

Damit der Empfänger 100 den genauen Zeitpunkt einer Nachricht ohne Synchronisation treffen kann, kann die Symbolrate des Übertragungsverfahrens so gering gewählt werden, dass die Laufzeit des Signals vernachlässigbar im Vergleich zur Übertragungsdauer eines einzelnen Symbols bleibt. Hierdurch ergibt sich der Zusammenhang, dass sich die mögliche Reichweite des Systems über die Symbolrate beeinflussen lässt. Zur Bestimmung des exakten Zeitpunkts des Eintreffens einer Nachricht gibt es verschiedene Möglichkeiten. Beispielhaft werden hier einige Methoden genannt, doch es sind auch andere Methoden denkbar dies zu erreichen. Eine erste Methode ist die absolute Zeit: Empfangen einer Nachricht jeden Tag um eine Festgelegte Uhrzeit. Erfordert entsprechend genaue und synchrone Uhren in Sender und Empfänger. Eine zweite Methode ist ein äußeres Ereignis: Ein Einfluss (Lichtimpuls, Geräusch, Radiowellen, usw.) zu Zeit t, welcher von Sender und Empfänger gleichermaßen wahrgenommen wird und den Empfang einer Nachricht zu einem Zeitpunkt t + Δt, Δt ≥ 0 am Knoten auslöst. Eine dritte Methode ist eine explizite Anforderung: Der Knoten verfügt über die Möglichkeit selbst Nachrichten zu senden und teilt der Basisstation so explizit mit wann er auf eine Nachricht wartet. Eine vierte Methode ist eine implizite Anforderung: Der Knoten sendet selbst regelmäßig Daten. Nach einer vorbestimmten Anzahl an gesendeten Nachrichten erwartet der Knoten eine Nachricht von der Basisstation. Die Zeitdifferenz zwischen senden der eigenen Nachricht und empfangen der Nachricht der Basis ist vorher festgelegt.

Kann der Zeitpunkt nicht ganz exakt vorausgesagt werden, so kann er mit Hilfe der Indikatoren genauer bestimmt werden. Es müssen aber keine spezielle Präambel zur Detektion eingefügt werden. Der Empfänger muss auch nicht kontinuierlich nach einem zu empfangenen Telegramm suchen.

Steht im Empfänger 100 nicht genügend Rechenleistung zur Echtzeit-Dekodierung des Telegramms zur Verfügung, so können die Empfangswerte oder teilweise demodulierten Empfangswerte zwischengespeichert werden.

Die Reduzierung des Überhangs durch zusätzliche Präambelsymbole und die daraus resultierende kürzere erforderliche Kanalnutzungsdauer zum Ansprechen eines einzelnen Knotens erlaubt es zudem die Anzahl der angesprochenen Knoten bei gleicher Gesamtnutzungdauer des Kanals zu erhöhen oder bei gleichbleibender Knotenanzahl die Störung anderer Systeme im gleichen Frequenzband zu verringern.

Bei Ausführungsbeispielen können die Nutzdaten von dem Datensender in zumindest zwei Datenpaketen aufgeteilt über den Kommunikationskanal gesendet werden. Die Einrichtung 106 zum Weiterverarbeiten von empfangenen Daten 112 kann dabei ausgebildet sein, um die empfangenen kanalcodierten Nutzdaten der zumindest zwei Datenpakte zu kombinieren, um durch die Kombination der empfangenen kanalcodierten Nutzdaten einen höheren Codegewinn für die Kanaldecodierung zu erhalten.

Durch das angewendete Telegram-Splitting Verfahren ist es auch möglich, den Empfängerknoten 100 mittels Energy-Harvesting oder Batterien zu betreiben, die den Empfänger 100 nicht direkt sondern nur über einen Energiezwischenspeicher (Kondensator) mit Strom versorgen können. Dieses ist möglich, da eine Nachricht nicht im Ganzen sondern in einzelnen Teilen (aufgeteilt über mehrere (zumindest zwei) Datenpakete) empfangen wird. Dies erlaubt es dem Empfänger 100 seine Energieversorgung zwischen den Datenpakete (Hops) 104 wieder aufzuladen und den weiteren Empfang zu ermöglichen. Um auf die spezifischen Anforderungen der Datenempfänger (Knoten) 100 und deren Energieversorgung einzugehen ist es dann möglich, die zeitliche Abfolge der Datenpakete (Hops) 104 so zu optimieren, dass der Empfang einer gesamten Nachricht mit einer bestimmten Wahrscheinlichkeit gewährleistet werden kann. Weiterhin kann der Empfänger 100 auf Basis seiner zur Verfügung stehenden Energie entscheiden, ob er einen Datenpaket (Hop) 104 empfängt oder nicht. Hat er bereits eine große Menge an Datenpaketen gesammelt, könnte es energetisch günstiger sein, ein Datenpaket 104 auszulassen, um erst mal wieder Energie einzusammeln.

Um die Übertragungsdauer zusätzlich zu kürzen, können jegliche Symbole zur Detektion und Frequenzschätzung weggelassen werden. Dies ist dann möglich, wenn der Sender 160 entsprechend leistungsfähige Hardware besitzt, um den Übermittlungszeitpunkt und die Übertragungsfrequenz des Empfängers 100 exakt zu treffen.

Durch das Verwenden besonders günstiger Komponenten im Datenempfänger (Knoten) 100 ist gerade das exakte Einstellen einer Empfangsfrequenz nicht immer möglich (Ungenauigkeiten und Alterung der Quarze). Für den Fall, dass die wirkliche Empfangsfrequenz des Datenempfängers (Knotens) zu stark von der eingestellten Frequenz abweicht, kann der Sender 160 die wirkliche Empfangsfrequenz bestimmen, um auf dieser zu senden.

Hierfür kann der Datenempfänger (Empfangsknoten) 100 vor dem Empfang der Nachricht schon selbst eine Nachricht auf einer vorher definierten Frequenz an die Basisstation gesendet haben. Auf dieser Frequenz wird dann das Paket 104 zurück gesendet (vgl. DE 10 2011 082 100 A1).

Eine weitere Maßnahme zur Reduzierung des Energieverbrauchs ergibt sich durch das vorzeitige Abbrechen des Empfangs einer Nachricht, wenn der Datenempfänger (Knoten) 100 feststellt, dass keine Nachricht übertragen wurde, eine Nachricht nicht für ihn bestimmt ist oder schon vor Empfang des letzten Datenpakets (Hops) 100 eine vordefinierte Mindestgesamtsicherheit unterschritten hat. Im letzteren Fall sind also die empfangenen Datenpakete (Hops) 100 schon so stark gestört, dass eine erfolgreiche Decodierung als unwahrscheinlich eingestuft wird, so kann der Empfang der restlichen Datenpakete (Hops) 100 und das Decodieren ausgesetzt werden um Energie zu sparen und der Empfänger kann sich in einen Modus mit sehr niedrigem Energieverbrauch setzen.

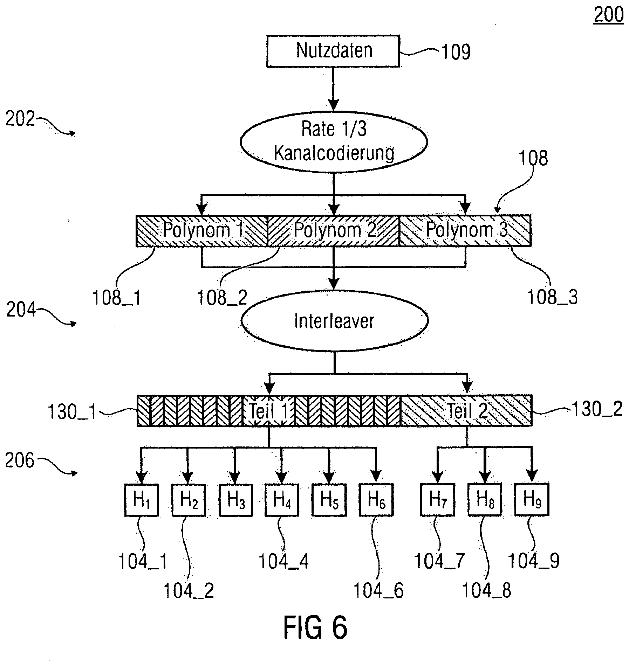

Eine Erweiterung dieses Verfahrens erlaubt weitere Einsparungen im Stromverbrauch durch entsprechendes Verteilen der kanalcodierten Nutzdatensymbole. So werden diese in der Nachricht so verteilt, dass schon nach Empfang eines Teils der gesamten Nachricht, bei entsprechender Sicherheit der Nutzdatensymbole, ein Decodiervorgang gestartet werden kann. Ist dieser erfolgreich, so ist es nicht mehr nötig den Rest der Nutzdaten zu empfangen und der Datenempfänger (Knoten) 100 muss somit über einen kürzeren Zeitraum im aktiven Empfangsmodus mit hohem Stromverbrauch verweilen, wie im Folgenden anhand von Fig. 6 erläutert wird.

Fig. 6 zeigt ein schematisches Flussdiagramm eines Verfahrens 200 zur Erzeugung von Datenpaketen 104, gemäß einem Ausführungsbeispiel der vorliegenden Erfindung. Mit anderen Worten, Fig. 6 zeigt eine beispielhafte Aufteilung der Kanalcodierten Symbole, um die Decodierung nach erfolgreichem Empfang eines Teils der Nachricht zu ermöglichen.

In einem ersten Schritt 202 können die Nutzdaten 109 (z.B. mit einer Coderate von 1/3) kanalcodiert werden, um kanalcodierte Nutzdaten 108 zu erhalten. Die kanalcodierten Nutzdaten 108 können beispielsweise zumindest drei Polynome 108_1 bis 108_3 von kanalcodierten Nutzdaten umfassen.

In einem zweiten Schritt 204 können die kanalcodierten Nutzdaten 108 zumindest teilweise miteinander verschachtelt werden, um zumindest zwei Teile 130_1 und 130_2 von unterschiedlich verschachtelten kanalcodierten Nutzdaten zu erhalten. Beispielsweise können die zumindest drei Polynome 108_1 bis 108_3 von kanalcodierten Nutzdaten einem Interleaver (Einrichtung zum Verschachteln) zugeführt werden, um die zumindest zwei Teile 130_1 und 130_2 von unterschiedlich verschachtelten kanalcodierten Nutzdaten zu erhalten. Wie in Fig. 6 zu erkennen ist, können das erste Polynom 108_1 und das zweite Polynom 108_2 von kanalcodierten Nutzdaten (vollständig) miteinander verschachtelt (engl. interleaved) werden, um den ersten Teil 130_1 von unterschiedlich verschachtelten kanalcodierten Nutzdaten zu erhalten, während das dritte Polynom 108_3 nicht verschachtelt wird, um den zweiten Teil 130_2 von unterschiedlich verschachtelten kanalcodierten Nutzdaten zu erhalten.

In einem dritten Schritt 206 können die um zumindest zwei Teile 130_1 und 130_2 von unterschiedlich verschachtelten kanalcodierten Nutzdaten in eine Mehrzahl von Datenpaketen 104_1 bis 104_9 aufgeteilt werden. Beispielsweise kann der erste Teil 130_1 von verschachtelten kanalcodierten Nutzdaten in sechs Datenpakete 104_1 (H₁) bis 104_6 (H₆) aufgeteilt werden, während der zweite Teil 130_2 von (verschachtelten) kanalcodierten Nutzdaten in drei Datenpakete 104_7 (H₇) bis 104_9 (H₉) aufgeteilt wird.

Das oben beschriebene Verfahren kann beispielsweise von dem Datensender 160 (oder der Einrichtung 164 zum Erzeugen von Datenpaketen des Datensenders 160) ausgeführt werden.

Als Beispiel zeigt Fig. 6, dass es genügen kann die Daten aller Datenpaket (Hops) 104_1 (H₁) bis 104_6 (He) vom ersten Teil 130_1 zu sammeln um den ersten Decodierungsversuch zu starten. Ist die Qualität der Datenpakete (Hops) 104_1 (H₁) bis 104_6 (H₆) ausreichend gewesen und die Decodierung erfolgreich, so ist der Empfang der fehlenden Datenpakete (Hops) 104_7 (H₇) bis 104_9 (H₉) nicht nötig.

Im Folgenden werden erzeugte Verbesserungen und Vorteile von Ausführungsbeispielen der vorliegenden Erfindung beschrieben.

Durch die aufgeteilte Übertragung (Telegram Splitting) können Empfänger 100, die über einen Energiezwischenspeicher betrieben werden, insgesamt längere Telegramme empfangen, dadurch kann eine höhere Übertragungsreichweite bei gegebener Informationsmenge bzw. eine höherer Informationsmenge bei gegebener Übertragungsreichweite erzielt werden.

Der Datenempfänger 100 erlaubt es, trotz der Limitierungen einfacher Empfangschips bei Störungen der Übertragung durch andere Funkteilnehmer eine robuste Datenübertragung von einer Basisstation zu einfachen Empfangsknoten zu ermöglichen.

Der Stromverbrauch kann durch Reduzierung der Empfangsdauer und die Einfachheit der Beurteilung der Symbolsicherheit weiter verringert werden. Falls kein Telegramm übertragen wurde durch frühzeitigen Abbruch des Empfangs. Falls ein Telegramm übertragen wurde, durch frühzeitigen Abbruch wenn das Telegramm mit einer Teildatenmenge schon korrekt empfangen werden kann.

Obwohl manche Ausführungsbeispiele beschrieben wurden, bei dem der Datenempfänger 100 ein Knoten und der Datensender eine Basisstation ist, sei darauf hingewiesen, dass die vorliegende Erfindung nicht auf solche Ausführungsbeispiele beschränkt ist. Vielmehr kann auch der Datensender 100 eine Basisstation und der Datenempfänger ein Knoten sein.

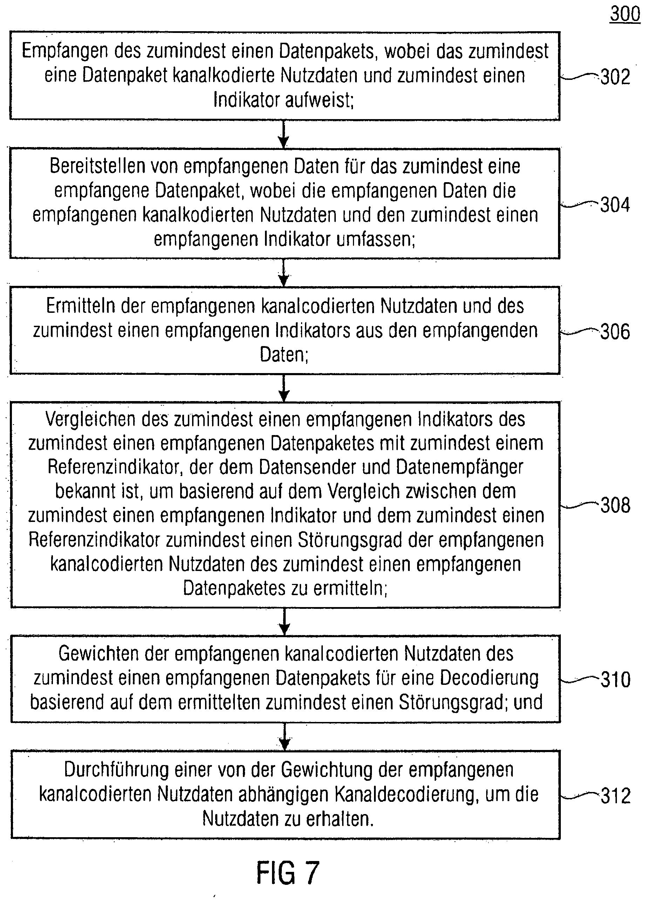

Fig. 7 zeigt ein Flussdiagramm 300 eines Verfahrens zum Empfangen von Nutzdaten, die von einem Datensender mittels zumindest eines Datenpakets über einen Kommunikationskanal gesendet werden. Das Verfahren 300 umfasst einen Schritt 302 des Empfangens des zumindest eine Datenpakets, wobei das zumindest eine Datenpaket kanalkodierte Nutzdaten, und zumindest einen Indikator aufweist; einen Schritt 304 des Bereitstellens von empfangene Daten für das zumindest eine empfangene Datenpaket, wobei die empfangenen Daten die empfangenen kanalkodierten Nutzdaten und den zumindest einen empfangenen Indikator umfassen; einen Schritt 306 des Ermittelns der empfangenen kanalcodierten Nutzdaten und des zumindest einen empfangene Indikators aus den empfangenden Daten; einen Schritt 308 des Vergleichens des zumindest einen empfangene Indikators des zumindest einen empfangenen Datenpaketes mit zumindest einem Referenzindikator, der dem Datensender und Datenempfänger bekannt ist, um basierend auf dem Vergleich zwischen dem zumindest einen empfangenen Indikator und dem zumindest einen Referenzindikator zumindest einen Störungsgrad der empfangenen kanalcodierten Nutzdaten des zumindest einen empfangenen Datenpaketes zu ermitteln; einen Schritt 310 des Gewichtens der empfangenen kanalcodierten Nutzdaten des zumindest einen empfangenen Datenpakets für eine Decodierung basierend auf dem ermittelten zumindest einen Störungsgrad; und einen Schritt 312 des Durchführens einer von der Gewichtung der empfangenen kanalcodierten Nutzdaten abhängigen Kanaldecodierung, um die Nutzdaten zu erhalten.

Im Folgenden, werden weitere Ausführungsbeispiele der vorliegenden Erfindung beschrieben.

Bei Empfängern, die mit entsprechend günstigen und sparsamen Chips ausgestattet sind, ist die Abschätzung der Qualität der Empfamgssymbole der einzelnen Datenpakete (Hops) nicht direkt aus den Ausgabedaten des Funkchips abzulesen. Für die Leistungsfähigkeit vieler Systeme ist jedoch genau diese Qualitätsbeurteilung ein essentieller Baustein. So ist die Performanz vieler Fehlerkorrekturmechanismen (z.B. Faltungsdecoder) entscheidend besser, wenn Informationen über die Qualität der Empfangssymbole vorliegt oder beim unterschreiten einer Qualitätsschwelle das Symbol als komplett unbekannt angenommen wird.

Neben der Qualitätsabschätzung ist im Hinblick auf den Energieverbrauch ebenso die Zeit in der sich der Empfänger in einem aktiven Empfangsmodus befindet zu minimieren.

Um diese beiden Kriterien auch mit einer einfachen, günstigen Hardware zu erfüllen, kann ein Übertragungsverfahren mit kurzen Paketen auf Basis des Paketaufteilungsverfahrens (engl. Telegram Splitting, siehe DE 10 2011 082 098 B4) verwendet werden, welches zudem zur Reichweitenerhöhung eine niedrige Datenrate nutzen kann. Durch Weglassen jeglicher Synchronisations- und Präambelsymbole kann die aktive Empfangszeit des Empfängers verkürzt werden. Um jedoch die Performanz zu verbessern werden wenige Zusatzsymbole (Indikatoren) eingefügt, um eine Qualitätsabschätzung für die Symbole eines einzelnen Datenpakets (Hops) oder Teildatenpakets (Teil-Hops) zu ermöglichen.

Dieses System ist insbesondere für das Verteilen von wenigen Informationen an viele Knoten interessant, da die kurze Paketlänge ohne viel zusätzlichen Überhang die begrenzte Kanalnutzungsdauer für einen einzelnen Knoten kurz hält und den Energieverbrauch am einzelnen Empfangsknoten ebenso minimiert. Zudem erhält die Übertragung durch die ermöglichte Qualitätsbeurteilung auch auf günstigen Funkchips die nötige Robustheit um in Frequenzbändern zusammen mit anderen Systemen benutzt zu werden, welche Interferenzen verursachen.

Der Knoten kann möglicherweise auch die eingefügten und bekannten Zusatzsymbole auch als Synchronisationsinformation verwenden um somit einen besseren Empfang (z.B. durch kohärentes Demodulieren oder Schätzung des Frequenzoffsets) zu ermöglichen.

Im Folgenden werden weitere Ausführungsbeispiele der vorliegenden Erfindung beschrieben.

Bei Ausführungsbeispielen kann die Basisstation eine kanalcodierte Nachricht im Telegrammaufteilungsverfahren zum Knoten senden. Dabei können wenige Indikatoren in einem Datenpaket (Hop) verteilt werden. Die Verteilung und Länge der Indikatoren kann auf das erwartete Störszenario und die Anforderungen an die Qualitätsschätzung angepasst werden. Optional können weitere (zusätzliche) Indikatoren eingefügt werden, um die Detektion und Frequenzschätzung zu ermöglichen. Optional kann die Sendefrequenz kann angepasst werden, um etwaige Abweichungen im Empfänger von der geplanten Frequenz (z.B. durch Ungenauigkeiten der Quarze) auszugleichen.

Bei Ausführungsbeispielen ist dem Empfänger der exakte Zeitpunkt, zu dem das Datenpaket 104 oder ein Indikator eintrifft, bekannt, so dass der Empfänger den Empfangschip zu diesem Zeitpunkt anschalten kann. Der Empfangszeitpunkt kann beispielsweise anhand der absoluten Zeit (GPS), eines äußerlichen Ereignisses oder durch eine bekannte Zeitdifferenz zu einem Ereignis bestimmt werden.

Bei Ausführungsbeispielen kann nach dem Empfang eines Datenpakets (Hops) anhand der Indikatorsymbole entschieden werden, ob das Datenpaket (Hop) oder Teile des Datenpakets (Hops) gestört wurden. Entsprechen alle Indikatoren dem vorher festgelegten Indikatormuster und sind einer Metrik entsprechend genügend richtig empfangen worden, so kann die Information des gesamten Datenpakets (Hops) als ungestört deklariert werden. Entsprechen die Indikatoren teilweise nicht dem erwarteten Symbol, so kann der Informationsteil zwischen den gestörten Indikator und dem nächsten Indikator als gestört deklariert werden.

Bei Ausführungsbeispielen kann die Information des Datenpakets verwendet werden, wenn das Datenpaket (Hop) ungestört ist. Ist das Datenpaket jedoch gestört, so kann dessen Information entweder verworfen oder mit einer geringeren Gewichtung weiterverwendet werden. Treten im Laufe des Empfangs einer Nachricht zu viele gestörte Datenpakete (Hop) oder Teildatenpakete (Teil-Hops) auf, so dass die Wahrscheinlichkeit eines fehlerlosen Empfangs bereits eine Schwelle unterschreitet, so kann der Empfang weiterer Datenpakete (Hops) abgebrochen werden um Energie zu sparen.

Bei Ausführungsbeispielen arbeitet der zumindest eine Indikator auf schon entschiedenen Symbolen, also wo die Synchronisation und Kanalschätzung entweder schon stattgefunden hat oder nicht notwendig ist. Der Einsatz von Indikatoren ist primär für den Fall gedacht, dass ein einfacher Empfänger verwendet wird, der keine Güteinformation über die Entschiedenen Symbole liefern kann.

Bei Ausführungsbeispielen kann der Datenempfänger einen Empfänger-IC (Funkchip) aufweisen, welcher die Synchronisation für den Nutzer schon übernommen hat und die Synchronisations- und Präambel-Symbole dem Nutzer nicht zur Verfügung stehen, da nur die Nutzdaten ausgegeben werden.

Bei Ausführungsbeispielen können die Indikatoren auf gebräuchlichen Funk-Empfänger-ICs (Funkchips) genutzt werden, die dem Anwender keine Möglichkeit zur Beeinflussung der Frequenz- oder Kanalschätzung geben. Aus den Fehlern in den Indikatoren kann dann die Richtige Gewichtungsfunktion für angrenzende Symbole gefunden werden, welche die Dekodierung der Kanalcodierten Daten dann verbessert.

Bei Ausführungsbeispielen kann der Datenempfänger einen Standard Funkchip aufweisen, der bereits entschiedene Bits am Ausgang liefert. Die Performance der Kanaldecodierung ist dabei schlechter als bei Soft-Decision-Empfängern (dt. Decoder, die eine Vorwärtsfehlerkorrektur berücksichtigen und keine harten, entschiedenen Bits bereitstellen). Mit der Störerdetektion über die Indikatoren kann die Performanz der Kanaldecodierung jedoch verbessert werden.

Weitere Ausführungsbeispiele befassen sich mit einem System zur Übertragung von Daten von einer Basisstation, z.B. Steuerdaten zur Anpassung einzelner Parameter eines Aktors oder Sensors, zu einem einzelnen oder einer großen Anzahl von einfachen Knoten. Die Rechenleistung sowie die Möglichkeiten der Funkkanalanalyse sind am Empfänger durch Kosten- und Energieverbrauchsüberlegungen nur eingeschränkt möglich. Im Gegensatz dazu steht an der Basisstation leistungsfähige Hardware zur Verfügung, die eine exakte Einstellung der Sendefrequenz und des Sendezeitpunktes erlaubt.

Weitere Ausführungsbeispiele befassen sich mit dem drahtlosen Übertragungsverfahren, das auch auf andere Anwendungsgebiete übertragen werden kann.

Weiter Ausführungsbeispiele schaffen einen Datenempfänger 100 zum Empfangen von Nutzdaten, die von einem Datensender mittels zumindest eines Datenpakets 104 über einen Kommunikationskanal gesendet werden, mit folgenden Merkmalen: einer Einrichtung 102 zum Empfangen von Datenpaketen, die ausgebildet ist, um das zumindest eine Datenpaket 104 zu empfangen, wobei das zumindest eine Datenpaket 104 kanalkodierte Nutzdaten 108 und zumindest einen Indikator 110 aufweist, wobei die Einrichtung 102 zum Empfangen von Datenpaketen ausgebildet ist, um für das zumindest eine empfangene Datenpaket 104 empfangene Daten 112, die die empfangenen kanalkodierten Nutzdaten 108 und den zumindest einen empfangenen Indikator 110 umfassen, auszugeben; einer Einrichtung 106 zum Weiterverarbeiten von empfangenen Daten 112, die ausgebildet ist, um aus den empfangenden Daten 112 die empfangenen kanalkodierten Nutzdaten 108 und den zumindest einen empfangenen Indikator 110 zu ermitteln, und um den zumindest einen empfangenen Indikator 110 des zumindest einen empfangenen Datenpakets 104 mit zumindest einem Referenzindikator, der dem Datensender und Datenempfänger 110 bekannt ist, zu vergleichen, und um basierend auf dem Vergleich zwischen dem zumindest einen empfangenen Indikator 110 und dem zumindest einen Referenzindikator zumindest einen Störungsgrad der empfangenen kanalcodierten Nutzdaten 108 des zumindest einen empfangenen Datenpaketes 104 zu ermitteln; wobei die Einrichtung 106 zum Weiterverarbeiten von empfangenen Daten 112 ausgebildet ist, um die empfangenen kanalcodierten Nutzdaten 108 des zumindest einen empfangenen Datenpakets 104 basierend auf dem ermittelten zumindest einen Störungsgrad für eine Decodierung zu gewichten, und um eine von der Gewichtung der empfangenen kanalcodierten Nutzdaten 108 abhängige Kanaldecodierung durchzuführen, um die Nutzdaten zu erhalten.

Bei den weiteren Ausführungsbeispielen kann der Datenempfänger 100 ausgebildet sein, um die Einrichtung 102 zum Empfangen von Datenpaketen zu deaktivieren, wenn genügend Datenpakete für die Kanaldecodierung empfangen wurden, um Energie zu sparen.

Bei den weiteren Ausführungsbeispielen kann der Datenempfänger 100 ausgebildet sein, um einen Empfang der Nutzdaten, die von dem Datensender in zumindest zwei Datenpaketen aufgeteilt gesendet werden, vorzeitig abzubrechen, wenn der Datenempfänger 100 feststellt dass
- keine Nutzdaten übertragen wurden;
- die Nutzdaten nicht für den Datenempfänger 100 sondern für einen anderen Datenempfänger bestimmt sind; oder
- eine für die Kanaldecodierung geforderte Mindestgesamtsicherheit unterschritten wurde.

Weitere Ausführungsbeispiele schaffen einen Datensender 160 zum Senden von Nutzdaten mittels zumindest eines Datenpakets 104 über einen Kommunikationskanal zu einem Datenempfänger 100, mit folgenden Merkmalen: einer Einrichtung 162 zum Kanalcodieren von Nutzdaten, die ausgebildet ist, um die Nutzdaten kanal zu codieren, um kanalcodierte Nutzdaten zu erhalten; einer Einrichtung 164 zum Erzeugen von Datenpaketen, die ausgebildet ist, um zumindest ein Datenpaket 104 aus den kanalcodierten Nutzdaten zu erzeugen, wobei die Einrichtung 164 zum Erzeugen von Datenpaketen ausgebildet ist, um die kanalcodierten Nutzdaten 108 mit zumindest einem Indikator 110, der dem Datensender 160 und Datenempfänger 100 bekannt ist, zu versehen; und einer Einrichtung 166 zum Senden von Datenpaketen, die ausgebildet ist, um das zumindest eine Datenpaket 104 über den Kommunikationskanal zu dem Datenempfänger 100 zu senden.

Bei den weiteren Ausführungsbeispielen kann die Einrichtung 164 zum Erzeugen von Datenpaketen ausgebildet sein, um zumindest zwei, unterschiedliche Teile der kanalcodierten Nutzdaten 108 zumindest teilweise miteinander zu verschachteln, um zumindest zwei Teile 130_1,130_2 von unterschiedlich verschachtelten kanalcodierten Nutzdaten zu erhalten; wobei die Einrichtung 164 zum Erzeugen von Datenpaketen ausgebildet ist, um die um zumindest zwei Teile 130_1,130_2 von unterschiedlich verschachtelten kanalcodierten Nutzdaten in eine Mehrzahl von Datenpaketen 104_1:104_9 aufzuteilen; und wobei die Einrichtung 166 zum Senden von Datenpaketen ausgebildet ist, um die Mehrzahl von Datenpaketen 104_1:104_9 zu senden.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder eine elektronische Schaltung ausgeführt werden. Bei einigen Ausführungsbeispielen können einige oder mehrere der wichtigsten Verfahrensschritte durch einen solchen Apparat ausgeführt werden.

Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer Blu-ray Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein.

Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft.

Der Programmcode kann beispielsweise auch auf einem maschinenlesbaren Träger gespeichert sein.

Andere Ausführungsbeispiele Umfassen das Computerprogramm zum Durchführen eines der hierin beschriebenen Verfahren, wobei das Computerprogramm auf einem maschinenlesbaren Träger gespeichert ist.

Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft.

Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Ein weiteres Ausführungsbeispiel gemäß der Erfindung umfasst eine Vorrichtung oder ein System, die bzw. das ausgelegt ist, um ein Computerprogramm zur Durchführung zumindest eines der hierin beschriebenen Verfahren zu einem Empfänger zu übertragen. Die Übertragung kann beispielsweise elektronisch oder optisch erfolgen. Der Empfänger kann beispielsweise ein Computer, ein Mobilgerät, ein Speichergerät oder eine ähnliche Vorrichtung sein. Die Vorrichtung oder das System kann beispielsweise einen Datei-Server zur Übertragung des Computerprogramms zu dem Empfänger umfassen.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen, Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

## Patentansprüche

1. Datenempfänger (100) zum Empfangen von Nutzdaten, die von einem Datensender mittels zumindest eines Datenpakets (104) über einen Kommunikationskanal gesendet werden, mit folgenden Merkmalen:
einer Einrichtung (102) zum Empfangen von Datenpaketen, die ausgebildet ist, um das zumindest eine Datenpaket (104) zu empfangen, wobei das zumindest eine Datenpaket (104) kanalkodierte Nutzdaten (108) und zumindest einen Indikator (110) aufweist, wobei die Einrichtung (102) zum Empfangen von Datenpaketen ausgebildet ist, um für das zumindest eine empfangene Datenpaket (104) empfangene Daten (112), die die empfangenen kanalkodierten Nutzdaten (108) und den zumindest einen empfangenen Indikator (110) umfassen, auszugeben;
einer Einrichtung (106) zum Weiterverarbeiten von empfangenen Daten (112), die ausgebildet ist, um aus den empfangenden Daten (112) die empfangenen kanalkodierten Nutzdaten (108) und den zumindest einen empfangenen Indikator (110) zu ermitteln, und um den zumindest einen empfangenen Indikator (110) des zumindest einen empfangenen Datenpakets (104) mit zumindest einem Referenzindikator, der dem Datensender und Datenempfänger (110) bekannt ist, zu vergleichen, und um basierend auf dem Vergleich zwischen dem zumindest einen empfangenen Indikator (110) und dem zumindest einen Referenzindikator zumindest einen Störungsgrad der empfangenen kanalcodierten Nutzdaten (108) des zumindest einen empfangenen Datenpaketes (104) zu ermitteln;
wobei die Einrichtung (106) zum Weiterverarbeiten von empfangenen Daten (112) ausgebildet ist, um die empfangenen kanalcodierten Nutzdaten (108) des zumindest einen empfangenen Datenpakets (104) basierend auf dem ermittelten zumindest einen Störungsgrad für eine Decodierung zu gewichten, und um eine von der Gewichtung der empfangenen kanalcodierten Nutzdaten (108) abhängige Kanaldecodierung durchzuführen, um die Nutzdaten zu erhalten;
wobei das zumindest eine Datenpaket (104) zumindest zwei Indikatoren (110_1:110_3) aufweist, die in dem Datenpaket (104) voneinander beabstandet angeordnet sind;
**gekennzeichnet dadurch, dass** die Einrichtung (106) zum Weiterverarbeiten von empfangenen Daten (112) ausgebildet ist, um einen Störungsgrad eines Teils der kanalcodierten Nutzdaten, der in dem Datenpaket (104) einen geringeren Abstand zu einem der zumindest zwei voneinander beabstandeten Indikatoren (110_1:110_3) aufweist, stärker in Abhängigkeit des Vergleichs des einen Indikators (110_1) mit dem entsprechenden Referenzindikator zu ermitteln als ein Teil der Nutzdaten, der in dem zumindest einen Datenpaket (104) einen größeren Abstand zu dem einen Indikator (110_1) aufweist.

2. Datenempfänger (100) nach Anspruch 1, wobei die Einrichtung (102) zum Empfangen von Datenpaketen ausgebildet ist, um die empfangenen Daten (112) in Form von bereits entschiedenen Bits auszugeben.

3. Datenempfänger (100) nach einem der Ansprüche 1 oder 2, wobei die Einrichtung (102) zum Empfangen von Datenpaketen ausgebildet ist, um keine Information über eine Qualität der empfangenen Daten (112) auszugeben.

4. Datenempfänger (100) nach einem der Ansprüche 1 bis 3, wobei die Einrichtung (102) zum Empfangen von Datenpaketen (104) ausgebildet ist, um den zumindest einen Indikator (110) nicht zum Empfangen des zumindest einen Datenpakets (104) zu verwenden.

5. Datenempfänger (100) nach einem der Ansprüche 1 bis 4, wobei das Datenpaket (104) einen Kontrolldatenbereich (118) und einen Nutzdatenbereich (116) aufweist, wobei der Nutzdatenbereich (116) als Daten die kanalcodierten Nutzdaten (108) und den zumindest einen Indikator (110) enthält;
wobei die Einrichtung (102) zum Empfangen von Datenpaketen ausgebildet ist, um die in dem Nutzdatenbereich (116) enthaltenen Daten als empfangene Daten (112) auszugeben.

6. Datenempfänger (100) nach Anspruch 5, wobei der Kontrolldatenbereich (118) eine Synchronisationssequenz enthält, wobei die Einrichtung (102) zum Empfangen von Datenpaketen ausgebildet ist, um eine Synchronisation des Datenpakets (104) unter Verwendung der Synchronisationssequenz durchzuführen.

7. Datenempfänger (100) nach einem der Ansprüche 5 oder 6, wobei die Einrichtung (102) zum Empfangen von Datenpaketen ausgebildet ist, um die in dem Kontrolldatenbereich enthaltenen Daten nicht auszugeben.

8. Datenempfänger (100) nach einem der Ansprüche 1 bis 7, wobei der zumindest eine Indikator (110) zumindest ein Indikatorsymbol (111_1:111_6) umfasst, wobei ein Indikatorsymbol (111_1:111_6) einem Symbol eines zur Übertragung des zumindest einen Datenpakets (104) verwendeten Modulationsverfahrens ist oder diesem entspricht.

9. Datenempfänger (100) nach Anspruch 8, wobei höchstens 30 % der zur Übertragung des Datenpakets (104) verwendeten Symbole des Modulationsverfahrens Indikatorsymbole sind, so dass der Datenempfänger (100) keine vollständige Synchronisation oder Frequenzschätzung basierend auf den Indikatorsymbolen (111_1:111_6) durchführen kann.

10. Datenempfänger (100) nach Anspruch 8, wobei in dem zumindest einen Datenpaket (104) höchstens vier Indikatorsymbole unmittelbar aufeinanderfolgend angeordnet sind, so dass der Datenempfänger keine vollständige Synchronisation oder Frequenzschätzung basierend auf den Indikatorsymbolen durchführen kann.

11. Datenempfänger (100) nach einem der Ansprüche 1 bis 10, wobei das zumindest eine Datenpaket (104) mehrere Indikatoren (110_1:110_3) aufweist, die in dem Datenpaket (104) verteilt angeordnet sind.

12. Datenempfänger (100) nach einem der Anspruch 1 bis 11, wobei der Einrichtung (106) zum Weiterverarbeiten von empfangen Daten (112) eine Anordnung, gemäß derer der zumindest eine Indikator (110) in dem Datenpaket (104) angeordnet ist, bekannt ist;
wobei die Einrichtung (106) zum Weiterverarbeiten von empfangen Daten (112) ausgebildet ist, um den zumindest einen Indikator (110) aus den empfangenen Daten (112) unter Verwendung der bekannten Anordnung zu ermitteln.

13. Datenempfänger (100) nach einem der Ansprüche 1 bis 12, wobei dem Datenempfänger (100) der Zeitpunkt des Eintreffens des zumindest einen Indikators (110) und/oder des zumindest einen Datenpakets (104) bekannt ist.

14. Datenempfänger (100) nach Anspruch 13, wobei der Datenempfänger (100) oder ein Zeitgeber des Datenempfängers (100) ausgebildet ist, um die Einrichtung (102) zum Empfangen von Datenpaketen für den Empfang des Datenpakets (104) zu aktivieren und nach dem Empfang des Datenpakets wieder zu deaktivieren, um Energie zu sparen.

15. Datenempfänger (110) nach einem der Ansprüche 1 bis 14, wobei die Nutzdaten von dem Datensender in zumindest zwei Datenpaketen aufgeteilt über den Kommunikationskanal gesendet werden;
wobei die Einrichtung (106) zum Weiterverarbeiten von empfangenen Daten ausgebildet ist, um die empfangenen kanalcodierten Nutzdaten (108) der zumindest zwei Datenpakte zu kombinieren, um durch die Kombination der empfangenen kanalcodierten Nutzdaten einen höheren Codegewinn für die Kanaldecodierung zu erhalten.

16. System (180), mit folgenden Merkmalen:
einem Datenempfänger (100) nach einem der Ansprüche 1 bis 15; und
einem Datensender (160), der ausgebildet ist, um das Datenpaket (104) mit den kanalcodierten Nutzdaten (108) und dem zumindest einen Indikator (110) zu dem Datenempfänger (100) über den Kommunikationskanal zu senden.

17. System (180) nach Anspruch 16, wobei der
Datensender (160) folgende Merkmale aufweist:
einer Einrichtung (162) zum Kanalcodieren von Nutzdaten, die ausgebildet ist, um die Nutzdaten kanal zu codieren, um kanalcodierte Nutzdaten zu erhalten;
einer Einrichtung (164) zum Erzeugen von Datenpaketen, die ausgebildet ist, um zumindest ein Datenpaket (104) aus den kanalcodierten Nutzdaten zu erzeugen, wobei die Einrichtung (164) zum Erzeugen von Datenpaketen ausgebildet ist, um die kanalcodierten Nutzdaten (108) mit zumindest einem Indikator (110), der dem Datensender (160) und Datenempfänger (100) bekannt ist, zu versehen; und
eine. Einrichtung (166) zum Senden von Datenpaketen, die ausgebildet ist, um das zumindest eine Datenpaket (104) über den Kommunikationskanal zu dem Datenempfänger (100) zu senden.

18. Verfahren (300) zum Empfangen von Nutzdaten, die von einem Datensender mittels zumindest eines Datenpakets über einen Kommunikationskanal gesendet werden, wobei das Verfahren aufweist:
Empfangen (302) des zumindest eine Datenpakets, wobei das zumindest eine Datenpaket kanalkodierte Nutzdaten und zumindest einen Indikator aufweist;
Bereitstellen (304) von empfangene Daten für das zumindest eine empfangene Datenpaket, wobei die empfangenen Daten die empfangenen kanalkodierten Nutzdaten und den zumindest einen empfangenen Indikator umfassen;
Ermitteln (306) der empfangenen kanalcodierten Nutzdaten und des zumindest einen empfangene Indikators aus den empfangenden Daten;
Vergleichen (308) des zumindest einen empfangene Indikators des zumindest einen empfangenen Datenpaketes mit zumindest einem Referenzindikator, der dem Datensender und Datenempfänger bekannt ist, um basierend auf dem Vergleich zwischen dem zumindest einen empfangenen Indikator und dem zumindest einen Referenzindikator zumindest einen Störungsgrad der empfangenen kanalcodierten Nutzdaten des zumindest einen empfangenen Datenpaketes zu ermitteln;
Gewichten (310) der empfangenen kanalcodierten Nutzdaten des zumindest einen empfangenen Datenpakets für eine Decodierung basierend auf dem ermittelten zumindest einen Störungsgrad; und
Durchführung (312) einer von der Gewichtung der empfangenen kanalcodierten Nutzdaten abhängigen Kanaldecodierung, um die Nutzdaten zu erhalten;
wobei das zumindest eine Datenpaket (104) zumindest zwei Indikatoren (110_1:110_3) aufweist, die in dem Datenpaket (104) voneinander beabstandet angeordnet sind;
**gekennzeichnet dadurch, dass** beim Vergleichen (308), ein Störungsgrad eines Teils der kanalcodierten Nutzdaten, der in dem Datenpaket (104) einen geringeren Abstand zu einem der zumindest zwei voneinander beabstandeten Indikatoren (110_1:110_3) aufweist, stärker in Abhängigkeit des Vergleichs des einen Indikators (110_1) mit dem entsprechenden Referenzindikator ermittelt wird als ein Teil der Nutzdaten, der in dem zumindest einen Datenpaket (104) einen größeren Abstand zu dem einen Indikator (110_1) aufweist.

19. Computerprogramm zur Durchführung eines Verfahrens nach Anspruch 18.

## Claims

1. Data receiver (100) for receiving payload data transmitted by a data transmitter by means of at least one data packet (104) via a communication channel, comprising:
means (102) for receiving data packets that is configured to receive the at least one data packet (104), wherein the at least one data packet (104) comprises channel-coded payload data (108) and at least one indicator (110), wherein the means (102) for receiving data packets is configured to output, for the at least one received data packet (104), received data (112) that include the received channel-coded payload data (108) and the at least one received indicator (110);
means (106) for further processing received data (112) that is configured to determine, from the received data (112), the received channel-coded payload data (108) and the at least one received indicator (110) and to compare the at least one received indicator (110) of the at least one received data packet (104) to at least one reference indicator that is known to the data transmitter and data receiver (110) and to determine, based on the comparison between the at least one received indicator (110) and the at least one reference indicator, at least one degree of interference of the received channel-coded payload data (108) of the at least one received data packet (104);
wherein the means (106) for further processing received data (112) is configured to weight the received channel-coded payload data (108) of the at least one received data packet (104) based on the determined at least one degree of interference for decoding and to perform channel decoding depending on the weighting of the received channel-coded payload data (108) for obtaining the payload data;
wherein the at least one data packet (104) comprises at least two indicators (110_1:110_3) that are arranged spaced apart from one another in the data packet (104);
**characterized in that** the means (106) for further processing received data (112) is configured to determine a degree of interference of part of the channel-coded payload data that has a lower distance to one of the at least two spaced-apart indicators (110_1:110_3) in the data packet (104) more strongly in dependence on the comparison of the one indicator (110_1) with the respective reference indicator than part of the payload data that has a greater distance to the indicator (110_1) in the at least one data packet (104).

2. Data receiver (100) according to claim 1, wherein the means (102) for receiving data packets is configured to output the received data (112) in the form of already decided bits.

3. Data receiver (100) according to one of claims 1 or 2, wherein the means (102) for receiving data packets is configured to output no information on a quality of the received data (112).

4. Data receiver (100) according to one of claims 1 to 3, wherein the means (102) for receiving data packets (104) is configured to use the at least one indicator (110) not for receiving the at least one data packet (104).

5. Data receiver (100) according to one of claims 1 to 4, wherein the data packet (104) comprises a control data region (118) and a payload data region (116), wherein the payload data region (116) includes the channel-coded payload data (108) and the at least one indicator (110) as data;
wherein the means (102) for receiving data packets is configured to output the data included in the payload data region (116) as received data (112).

6. Data receiver (100) according to claim 5, wherein the control data region (118) includes a synchronization sequence, wherein the means (102) for receiving data packets is configured to perform synchronization of the data packet (104) by using the synchronization sequence.

7. Data receiver (110) according to one of claims 5 or 6, wherein the means (102) for receiving data packets is configured to not output the data included in the control data region.

8. Data receiver (100) according to one of claims 1 to 7, wherein the at least one indicator (110) includes at least one indicator symbol (111_1:111_6), wherein an indicator symbol (111_1:111_6) is a symbol of a modulation method used for transmitting the at least one data packet (104) or corresponds to the same.

9. Data receiver (100) according to claim 8, wherein at most 30% of the symbols of the modulation method used for transmitting the data packet (104) are indicator symbols, such that the data receiver (100) cannot perform complete synchronization or frequency estimation based on the indicator symbols (111_1:111_6).

10. Data receiver (100) according to claim 8, wherein, in the at least one data packet (104), at most four indicator symbols are arranged in an immediately successive manner, such that the data receiver cannot perform complete synchronization or frequency estimation based on the indicator symbols.

11. Data receiver (100) according to one of claims 1 to 10, wherein the at least one data packet (104) comprises several indicators (110_1:110_3) that are arranged in the data packet (104) in a distributed manner.

12. Data receiver (100) according to one of claims 1 to 11, wherein the means (106) for further processing received data (112) knows an arrangement according to which the at least one indicator (110) is arranged in the data packet (104);
wherein the means (106) for further processing received data (112) is configured to determine the at least one indicator (110) from the received data (112) by using the known arrangement.

13. Data receiver (100) according to one of claims 1 to 12, wherein the data receiver (100) knows the time of arrival of the at least one indicator (110) and/or the at least one data packet (104).

14. Data receiver (100) according to claim 13, wherein the data receiver (100) or a timer of the data receiver (100) is configured to activate the means (102) for receiving data packets for the reception of the data packet (104) and to deactivate the same again after reception of the data packet for saving energy.

15. Data receiver (110) according to one of claims 1 to 14, wherein the payload data, divided into at least two data packets, are transmitted by the data transmitter via the communication channel;
wherein the means (106) for further processing received data is configured to combine the received channel-coded payload data (108) of the at least two data packets in order to obtain a higher code gain for channel decoding by the combination of the received channel-coded payload data.

16. System (180), comprising:
a data receiver (100) according to one of claims 1 to 15; and
a data transmitter (160) that is configured to transmit the data packet (104) with the channel-coded payload data (108) and the at least one indicator (110) to the data receiver (100) via the communication channel.

17. System (180) according to claim 16, wherein the data transmitter (160) comprises:
means (162) for channel-coding payload data that is configured to channel-code the payload data to obtain channel-coded payload data;
means (164) for generating data packets that is configured to generate at least one data packet (104) from the channel-coded payload data, wherein the means (164) for generating data packets is configured to provide the channel-coded payload data (108) with at least one indicator (110) that is known to the data transmitter (160) and the data receiver (100); and
means (166) for transmitting data packets that is configured to transmit the at least one data packet (104) via the communication channel to the data receiver (100).

18. Method (300) for receiving payload data that are transmitted by a data transmitter by means of at least one data packet via a communication channel, the method comprising:
receiving (302) the at least one data packet, wherein the at least one data packet comprises channel-coded payload data and the at least one indicator;
providing (304) received data for the at least one received data packet, wherein the received data include the received channel-coded payload data and the at least one received indicator;
determining (306) the received channel-coded payload data and the at least one received indicator from the received data;
comparing (308) the at least one received indicator of the at least one received data packet to at least one reference indicator that is known to the data transmitter and data receiver to determine, based on the comparison between the at least one received indicator and the at least one reference indicator, at least one degree of interference of the received channel-coded payload data of the at least one received data packet;
weighting (310) the received channel-coded payload data of the at least one received data packet for decoding based on the determined at least one degree of interference; and
performing (312) channel decoding depending on the weighting of the received channel-coded payload data for obtaining the payload data;
wherein the at least one data packet (104) comprises at least two indicators (110_1:110_3) that are arranged spaced apart from one another in the data packet (104);
**characterized in that**, when comparing (308), a degree of interference of part of the channel-coded payload data that has a lower distance to one of the at least two spaced-apart indicators (110_1:110_3) in the data packet (104) is determined more strongly in dependence on the comparison of the one indicator (110_1) with the respective reference indicator than part of the payload data that has a greater distance to the indicator (110_1) in the at least one data packet (104).

19. Computer program for performing a method according to claim 18.

## Revendications

1. Récepteur de données (100) pour recevoir des données utiles qui sont envoyées par un émetteur de données au moyen d'au moins un paquet de données (104) via un canal de communication, aux caractéristiques suivantes:
un moyen (102) destiné à recevoir des paquets de données qui est configuré pour recevoir l'au moins un paquet de données (104), où ledit au moins un paquet de données (104) présente des données utiles codées de canal (108) et au moins un indicateur (110), où le moyen (102) destiné à recevoir des paquets de données est conçu pour sortir, pour l'au moins un paquet de données reçu (104), les données reçues (112) qui comportent les données utiles codées de canal reçues (108) et l'au moins un indicateur reçu (110);
un moyen (106) destiné à traiter les données reçues (112) qui est conçu pour déterminer, à partir des données reçues (112), les données utiles codées de canal reçues (108) et l'au moins un indicateur reçu (110), et pour comparer l'au moins un indicateur reçu (110) de l'au moins un paquet de données reçu (104) avec au moins un indicateur de référence qui est connu de l'émetteur de données et du récepteur de données (110), et pour déterminer, sur base de la comparaison entre l'au moins un indicateur reçu (110) et l'au moins un indicateur de référence, au moins un degré de brouillage des données utiles codées de canal reçues (108) de l'au moins un paquet de données reçu (104);
dans lequel le moyen (106) destiné à traiter les données reçues (112) est conçu pour pondérer les données utiles codées de canal reçues (108) de l'au moins un paquet de données reçu (104) sur base de l'au moins un degré, de brouillage déterminé pour un décodage, et pour effectuer un décodage de canal dépendant de la pondération des données utiles codées de canal reçues (108) pour obtenir les données utiles;
dans lequel l'au moins un paquet de données (104) présente au moins deux indicateurs (110_1:110_3) qui sont disposés distants l'un de l'autre dans le paquet de données (104);
**caractérisé par le fait que** le moyen (106) destiné à traiter les données reçues (112) est conçu pour déterminer un degré de brouillage d'une partie des données utiles codées de canal qui présente, dans le paquet de données (104), une moindre distance de l'un des au moins deux indicateurs espacés (110_1:110_3) plus fortement en fonction de la comparaison de l'un indicateur (110_1) avec l'indicateur de référence correspondant qu'une partie des données utiles qui présente, dans l'au moins un paquet de données (104), une plus grande distance de l'un indicateur (110_1).

2. Récepteur de données (100) selon la revendication 1, dans lequel le moyen (102) destiné à recevoir des paquets de données est conçu pour sortir les données reçues (112) sous forme de bits déjà décidés.

3. Récepteur de données (100) selon l'une des revendications 1 ou 2, dans lequel le moyen (102) destiné à recevoir des paquets de données est conçu pour ne pas sortir d'informations sur une qualité des données reçues (112).

4. Récepteur de données (100) selon l'une des revendications 1 à 3, dans lequel le moyen (102) destiné à recevoir des paquets de données (104) est conçu pour ne pas utiliser l'au moins un indicateur (110) pour recevoir l'au moins un paquet de données (104).

5. Récepteur de données (100) selon l'une des revendications 1 à 4, dans lequel le paquet de données (104) présente une zone de données de contrôle (118) et une zone de données utiles (116), où la zone de données utiles (116) contient, comme données, les données utiles codées de canal (108) et l'au moins un indicateur (110);
dans lequel le moyen (102) destiné à recevoir des paquets de données est conçu pour sortir les données contenues dans la zone de données utiles (116) comme données reçues (112).

6. Récepteur de données (100) selon la revendication 5, dans lequel la zone de données de contrôle (118) contient une séquence de synchronisation, dans lequel le moyen (102) destiné à recevoir des paquets de données est conçu pour effectuer une synchronisation du paquet de données (104) à l'aide de la séquence de synchronisation.

7. Récepteur de données (100) selon l'une des revendications 5 ou 6, dans lequel le moyen (102) destiné à recevoir des paquets de données est conçu pour ne pas sortir les données contenues dans la zone de données de contrôle.

8. Récepteur de données (100) selon l'une des revendications 1 à 7, dans lequel l'au moins un indicateur (110) comporte au moins un symbole d'indicateur (111_1:111_6), où un symbole d'indicateur (111_1:111_6) est un symbole d'un procédé de modulation utilisé pour transmettre l'au moins un paquet de données (104) ou correspond à ce dernier.

9. Récepteur de données (100) selon la revendication 8, dans lequel tout au plus 30% des symboles du procédé de modulation utilisés pour transmettre le paquet de données (104) sont des symboles d'indicateur, de sorte que le récepteur de données (100) ne puisse pas effectuer de synchronisation ou d'estimation de fréquence complète sur base des symboles d'indicateur (111_1:111_6).

10. Récepteur de données (100) selon la revendication 8, dans lequel sont disposés, dans l'au moins un paquet de données (104), immédiatement l'un après l'autre tout au plus quatre symboles d'indicateur de sorte que le récepteur de données ne puisse pas effectuer de synchronisation ou d'estimation de fréquence complète sur base des symboles d'indicateur.

11. Récepteur de données (100) selon l'une des revendications 1 à 10, dans lequel l'au moins un paquet de données (104) présente plusieurs indicateurs (110_1:110_3) qui sont disposés répartis dans le paquet de données (104).

12. Récepteur de données (100) selon l'une des revendications 1 à 11, dans lequel est connu du moyen (106) destiné à traiter les données reçues (112) un aménagement selon lequel l'au moins un indicateur (110) est disposé dans le paquet de données (104);
dans lequel le moyen (106) destiné à traiter les données reçues (112) est conçu pour déterminer l'au moins un indicateur (110) à partir des données reçues (112) à l'aide de l'aménagement connu.

13. Récepteur de données (100) selon l'une des revendications 1 à 12, dans lequel est connu du récepteur de données (100) le moment d'arrivée de l'au moins un indicateur (110) et/ou de l'au moins un paquet de données (104).

14. Récepteur de données (100) selon la revendication 13, dans lequel le récepteur de données (100) ou une minuterie du récepteur de données (100) est conçu/conçue pour activer le moyen (102) destiné à recevoir des paquets de données pour recevoir le paquet de données (104) et pour le désactiver à nouveau après réception du paquet de données, afin d'économiser de l'énergie.

15. Récepteur de données (110) selon l'une des revendications 1 à 14, dans lequel les données utiles sont envoyées par l'émetteur de données divisées en au moins deux paquets de données via le canal de communication;
dans lequel le moyen (106) destiné à traiter les données reçues est conçu pour combiner les données utiles codées de canal reçues (108) des au moins deux paquets de données pour obtenir, par la combinaison des données utiles codées de canal reçues, un gain de code supérieur pour le décodage de canal.

16. Système (180), aux caractéristiques suivantes:
un récepteur de données (100) selon l'une des revendications 1 à 15; et
un émetteur de données (160) qui est conçu pour envoyer le paquet de données (104) avec les données utiles codées de canal (108) et l'au moins un indicateur (110) au récepteur de données (100) via le canal de communication.

17. Système (180) selon la revendication 16, dans lequel l'émetteur de données (160) présente:
un moyen (162) destiné à coder de canal des données utiles, qui est conçu pour coder de canal les données utiles pour obtenir des données utiles codées de canal;
un dispositif (164) destiné à générer des paquets de données qui est configuré pour générer au moins un paquet de données (104) à partir des données utiles codées de canal, où le moyen (164) destiné à générer des paquets de données est conçu pour pourvoir les données utiles (108) codées de canal d'au moins un indicateur (110) qui est connu de l'émetteur de données (160) et du récepteur de données (100); et
un moyen (166) destiné à envoyer des paquets de données qui est conçu pour envoyer l'au moins un paquet de données (104) au récepteur de données (100) via le canal de communication.

18. Procédé (300) de réception de données utiles qui sont envoyées par un émetteur de données au moyen d'au moins un paquet de données via un canal de communication, le procédé comprenant le fait de:
recevoir (302) l'au moins un paquet de données, où l'au moins un paquet de données présente des données utiles codées de canal et au moins un indicateur;
mettre à disposition (304) les données reçues pour l'au moins un paquet de données reçu, où les données reçues comportent les données utiles codées de canal reçues et l'au moins un indicateur reçu;
déterminer (306) les données utiles codées de canal reçues et l'au moins un indicateur reçu à partir des données reçues;
comparer (308) l'au moins un indicateur reçu de l'au moins un paquet de données reçu avec au moins un indicateur de référence qui est connu de l'émetteur de données et du récepteur de données, pour déterminer, sur base de la comparaison entre l'au moins un indicateur reçu et l'au moins un indicateur de référence, au moins un degré de brouillage des données utiles codées de canal reçues de l'au moins un paquet de données reçu;
pondérer (310) les données utiles codées de canal reçues de l'au moins un paquet de données reçu pour un décodage sur base de l'au moins un degré de brouillage déterminé; et
effectuer (312) une décodage de canal dépendant de la pondération des données utiles codées de canal reçues, pour obtenir les données utiles;
dans lequel l'au moins un paquet de données (104) présente au moins deux indicateurs (110_1:110_3) disposés distants l'un de l'autre dans le paquet de données (104);
**caractérisé par le fait que**, lors de la comparaison (308), un degré brouillage d'une partie des données utiles codées de canal qui présente, dans le paquet de données (104), une moindre distance de l'un des au moins deux indicateurs distants l'un de l'autre (110_1:110_3), est déterminé plus fortement en fonction de la comparaison de l'un indicateur (110_1) avec l'indicateur de référence correspondant qu'une partie des données utiles qui présente, dans l'au moins un paquet de données (104), une plus grande distance de l'indicateur (110_1).

19. Programme d'ordinateur pour réaliser un procédé selon la revendication 18.
